(19) **Europäisches Patentamt / European Patent Office / Office européen des brevets**

(11) **EP 4 576 085 A1**

(12) **EUROPEAN PATENT APPLICATION**

(43) Date of publication:
**25.06.2025 Bulletin 2025/26**

(21) Application number: **23220057.6**

(22) Date of filing: **22.12.2023**

(51) International Patent Classification (IPC):
*G11C 5/04* *(2006.01)*    *G11C 29/00* *(2006.01)*
*H01L 21/66* *(2006.01)*    *H01L 23/00* *(2006.01)*
*B23K 26/00* *(2014.01)*    *G03F 7/00* *(2006.01)*
*G11C 29/02* *(2006.01)*    *G11C 29/06* *(2006.01)*
*G11C 29/56* *(2006.01)*    *H01L 21/683* *(2006.01)*
*H01L 23/544* *(2006.01)*    *H01L 25/00* *(2006.01)*
*H01L 25/065* *(2023.01)*

(52) Cooperative Patent Classification (CPC):
**H01L 22/12; H01L 22/26; H01L 24/80;** B23K 26/00;
G03F 7/00; G11C 5/04; G11C 29/006; G11C 29/02;
G11C 29/028; G11C 29/06; G11C 29/56008;
G11C 29/56016; H01L 21/6835; H01L 23/544;
H01L 25/0657;      (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: ASML Netherlands B.V.
**5500 AH Veldhoven (NL)**

(72) Inventors:
• **VAN DEN BRINK, Marinus, Aart**
**5500 AH Veldhoven (NL)**
• **BEUKMAN, Arjan, Johannes, Anton**
**5500 AH Veldhoven (NL)**
• **SOKOLOV, Sergei**
**5500 AH Veldhoven (NL)**

(74) Representative: **ASML Netherlands B.V.
Corporate Intellectual Property
P.O. Box 324
5500 AH Veldhoven (NL)**

(54) **SYSTEM AND METHOD FOR STRESS RELEASE IN DIE BONDING**

(57)    A system and method for generating a pattern of stress features, the pattern of stress features configured to alter locations of multiple fabricated features of a manufactured semiconductor die; and applying at least part of the pattern of stress features to the semiconductor die to adjust locations of the multiple fabricated features.

FIG. 5

**EP 4 576 085 A1**

(52) Cooperative Patent Classification (CPC): (Cont.)
H01L 25/50

**Description**

TECHNICAL FIELD

The present disclosure relates generally to a method and system for stress release in die bonding.

BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other devices, may rely upon joining of specific portions (for example, conductive contact elements) of multiple die-where these specific portions may be aligned in three-dimensional space to ensure functional connectivity. Alignment of these die, which may have multiple fabrication layers, different critical dimensions, different nodes, packaging, etc., with each other may require different techniques than used for lithography during fabrication. Additionally, errors (e.g., differences from a planned layout) may be induced in the die themselves by processing (e.g., imaging errors, patterning errors, etc.), including by die bonding (e.g., stress-induced pattern distortion such as resulting from thermal distortion, chucking variations, etc.). One or more apparatuses may be used to correct (e.g., at least partially, if not wholly) one or more of the errors, including before and/or after die bonding. As the physical sizes of IC components continue to shrink, and their structures continue to become more complex, accuracy and throughput in integration become more important. For applications such as heterogeneous integration, it may be desirable to obtain both accurate and fast placement of die with respect to one another, which may require error reduction and/or correction. In the context of semiconductor manufacture, improvements in die placement and alignment (e.g., improvements in heterogeneous integration) lead to improvements in IC manufacturing and integration abilities.

SUMMARY

According to an embodiment, there is provided a method comprising:

generating a pattern of stress features, the pattern of stress features configured to alter locations of multiple fabricated features of a semiconductor die; and
applying at least part of the pattern of stress features to the semiconductor die to adjust locations of the multiple fabricated features.

According to an embodiment, there is provided one or more non-transitory, machine-readable medium having instructions thereon, the instructions, when executed by a processor system, configured to cause the processor system to at least:

obtain measured locations of multiple fabricated features on at least one area of a semiconductor die;
obtain planned locations of the multiple fabricated features on the at least one area of the semiconductor die;
determine a difference between the measured fabricated locations of the multiple features and the planned locations of the multiple fabricated features; and
generate a pattern of stress features, the pattern of stress features configured to alter the locations of the multiple fabricated features based on the determined difference.

According to an embodiment, there is provided one or more non-transitory, machine-readable medium having instructions thereon, the instructions, when executed by a processor system, configured to cause the processor system to at least:

determine a distortion in measured fabricated locations of multiple fabricated features on at least one area of a semiconductor die, the distortion resulting at least partially from stress in a bonding or fabrication process; and
generate a pattern of stress features, the pattern of stress features configured to alter the distortion of the multiple fabricated features by altering the stress present in the semiconductor die.

According to an embodiment, there is provided a system comprising:

a targeted emission system configured to induce stress features in a semiconductor die; and
a processor system configured to:

obtain a pattern of stress features, the pattern of stress features configured to alter a distortion of the semiconductor die; and

cause the targeted emission system to generate stress features in the semiconductor die based on the pattern of stress features.

According to an embodiment, there is provided a manufactured semiconductor die having a pattern of stress features, the pattern of stress features having altered locations of multiple fabricated features of the semiconductor die.

According to an embodiment, there is provided one or more non-transitory, machine-readable medium is provided having instructions thereon, the instructions when executed by a processor being configured to perform a method as described herein.

BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Figures 1A-1D are schematic diagrams illustrating an exemplary die bonding method, according to one or more embodiments.

Figures 2A-2F are schematic diagrams illustrating an example method of die placement, according to one or more embodiments.

Figures 3A-3J are schematic diagrams illustrating portions of an example apparatus for die bonding, according to one or more embodiments.

Figure 4 is a schematic diagram illustrating a relationship between metrology and a position modification system, according to one or more embodiments.

Figure 5 is a schematic diagram illustrating portions of an example apparatus for stress release and/or induction in one or more die, according to one or more embodiments.

Figure 6 is a flowchart which illustrates an exemplary method of die stress modification, according to one or more embodiments.

Figure 7 is a flowchart which illustrates an exemplary method of die placement, according to one or more embodiments.

Figure 8 is a schematic representation of an exemplary distortions, patterns of stress features, and corrections to the distortion by application of the patterns of stress features, according to one or more embodiments.

Figures 9A-9B are schematic diagrams illustrating correction of feature locations by application of a pattern of stress features for an exemplary die, according to one or more embodiments.

Figure 10 is a block diagram of an example computer system, according to one or more embodiments of the present disclosure.

DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion," respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer"-that is a "die" may be produced by dicing or otherwise dividing a "wafer." The term "die" should be considered as interchangeable with the term chip, chiplet, or other terms for IC divisions. While one or more substrates/wafers herein are depicted as being of circular shape, they can be of any shape, including rectangular, and have any shape of die. While one or more dies herein are depicted as being of rectangular shape, they can be of any shape, including circular. As used throughout this application "or," unless indicated otherwise, takes a non-exclusive meaning, e.g., encompassing both "and" and "or." "Each," "every," "all," "corresponding," "individual" and other relational terms encompass substantially "each," "every," "all," etc., including cases in which each, every, all, corresponding, individual, etc. may include relationship which are not one-to-one, or do not include every possible item. For example, every may exclude items, such as items determined to be defective during testing. Each may exclude items, such as edge items, which are not used. All may exclude items, such as excess items. Corresponding may not require that items correspond in an exactly one to one manner. For example, a first item may correspond to two of a second item or vice versa. In some cases, individual may refer to multiple of an item, such as each item A has individual item B, where an item A may have two of an item B.

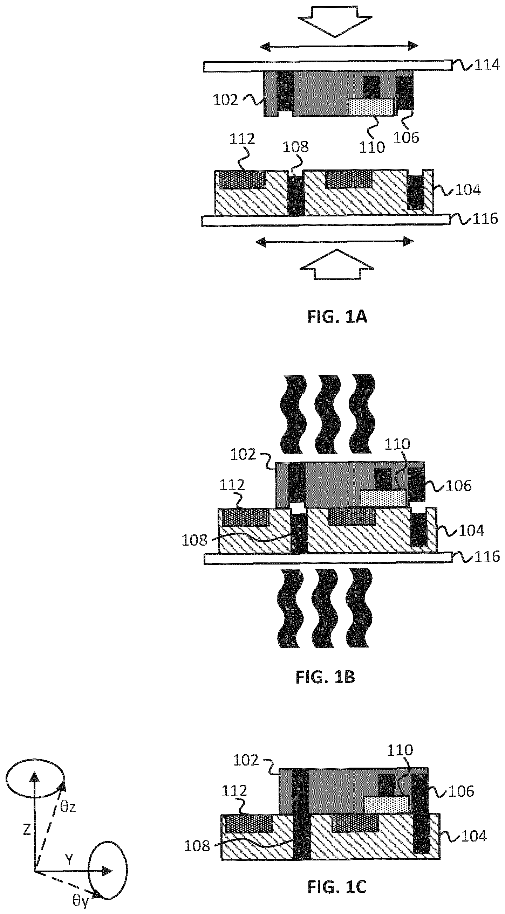

Reference is now made to Figures 1A-1D, which are schematic diagrams illustrating an exemplary die bonding method consistent with embodiments of the present disclosure. The exemplary die bonding method is depicted in relation to a reference set of axes, which are consistent through the schematic illustrations. The reference axes are provided for ease of description only and are not to be taken as limiting. Included methods and apparatuses may instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The reference set of axes is chosen such that the fabrication plane of the die (i.e., a substrate surface) lies in the X-Y plane and where the fabrication direction is parallel or antiparallel to the Z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "target" are provided for reference and are relative descriptions, and that elements described as corresponding to a "donor" can instead correspond to a "target" and vice versa. A target die may also or instead be called an acceptor die. Further, while just one donor die and target die are depicted in Figure 1A, it will be appreciated that there may be multiple such die and that multiple donor die may be essentially simultaneously bonded with multiple target die, e.g., where, for example, multiple die are still part of (all or part) a substrate in or on which they are formed.

The donor die 102 may have one or more electrically active areas 106, such as on an alignment face of the donor die 102. The one or more electrically active areas 106 may be conductive, such as metal. The one or more electrically active areas 106 may correspond to one or more vias (e.g., one or more through silicon vias (TSVs)), one or more electrical contact lines, one or more contact pads, one or more packaging pads, or other one or more electrically conductive areas. The donor die 102 may have one or more electrically inert areas (for example, an electrically insulating area) outside of the one or more electrically active areas 106, such as on the alignment face of the donor die 102. The one or more electrically active areas 106 may be recessed (as shown) with respect to one or more other surfaces of the donor die 102. The one or more electrically active areas 106 may correspond to one or more contacts (e.g., to source, to drain, to gate, etc.) to one or more electrical devices within the donor die 102 (not shown). The target die 104, likewise, may have one or more electrically active areas 108, which may have one or more similar properties to the one or more electrically active areas 106.

The donor die 102 may also or instead have one or more doped areas 110, such as on an alignment face of the donor die 102, recessed below the alignment face of the donor die 102, etc. While the term "doped" is used, it should be understood that the one or more doped areas 110 may be any areas which, through the course of fabrication, come to have one or more different electrical characteristics than the bulk of the substrate (e.g., silicon wafer). The one or more doped areas 110 may correspond to source, drain, gate, ground, or other areas of a circuit which is doped or otherwise altered (e.g., through implantation, oxide growth, thin film deposition, etc.) to have a different electrical characteristic than the bulk of the substrate. The one or more doped areas 110 may include one or more conductive layers (e.g., one or more highly doped or electrically conductive layers) and/or one or more insulative layers (e.g., one or more oxide layers). The donor die 102 may have one or more undoped areas (for example, an area where the substrate retains the characteristic of the bulk substrate) outside of the one or more doped areas 110, such as on the alignment face of the donor die 102. The one or more doped areas 110 may be recessed, buried, coplanar (as shown), etc. with respect to one or more other surfaces of the donor die 102. The one or more doped areas 110 may correspond to one or more regions (e.g., to one or more source regions, one or more drain regions, one or more gate regions, one or more dielectric regions, etc.) of one or more electrical devices within the donor die 102 or one or more regions which may form one or more electrical devices across both the donor die 102 and the acceptor die 104 once those die are bonded. The target die 104, likewise, may have one or more doped areas 112, which may have one or more similar properties to the one or more doped areas 110.

As shown in Figures 1A and 1B, the exemplary die bonding method may involve alignment of at least one of the electrically active areas 106 and/or doped areas 110 of the donor die 102 with at least one of the electrically active areas 108 and/or doped areas 112 of the target die 104. The exemplary die bonding method may involve bringing the donor die 102 into contact with the target die 104 while maintaining alignment between, e.g., one or more electrically active areas 106 and one or more electrically active areas 108 so that the one or more electrically active areas 106 and the one or more electrically active areas 108 may be joined for cross-die electrical communication. The exemplary die bonding method may involve aligning one or more doped areas 110 of the donor die 102 with one or more doped areas 112 of the target die 104. Aligning may encompass bringing into contact, aligning one or more edges of various regions, having overlap, having non-overlap, or any other appropriate alignment scheme. In some embodiments, aligning may encompass correcting, such as through stress induction, stress release, etc. locations of one or more areas of the die (e.g., the electrically active areas 106 and/or doped areas 110 of the donor die 102 and/or the electrically active areas 108 and/or doped areas 112 of the target die 104). In some embodiments, aligning may encompass correcting, such as through stress induction, stress release, etc. a distortion (e.g., placement error) in one or more dies (e.g., the donor die 102 and/or the target die 104), substrates, etc. The exemplary die bonding method may involve applying or maintaining pressure between the donor die 102 and the target die 104, while bonding occurs between the donor die 102 and the target die 104. The donor die 102 may be supported by a carrier structure 114, which may be a substrate which is transparent to a range of radiation (e.g., infrared radiation, a portion of the optical spectrum, etc.). The target die 104 may likewise be supported by a carrier structure 116, which may or may not be transparent to a range of radiation. Alternatively, the target die 104 (possibly together with the carrier structure) may be part of an undiced or partially diced target wafer. The alignment may be complicated by the multiple layers of the donor die 102 or the multiple layers of the target die 104, which may be optically opaque.

Figures 1A and 1B depict a cross-sectional view of portions of the exemplary die bonding method showing relative positioning between the donor die 102 and the target die 104. As shown in Figure 1A, the donor die 102 and the target die 104 may be brought together along the Z-axis, while the position of the donor die 102 or the target die 104 may be adjusted in the X-Y plane (e.g., perpendicular to the Z-axis of approach), such as to improve alignment between the donor die 102 and the target die 104. As shown in Figure 1B, alignment can be achieved between, e.g., one or more electrically active areas 106 and one or more electrically active areas 108 and/or between one or more doped areas 110 of the donor die 102 with one or more doped areas 112 of the target die 104.

Once aligned, the donor die 102 and the target die 104 are bonded together. In an embodiment, the bonding is a direct or fusion bonding (e.g., involving van der Waals forces). In an embodiment, the bonding is an intermolecular bonding, e.g., van der Waals bonding. In an embodiment, the bonding may include covalent, ionic, or metallic (e.g., chemical) bonding. In an embodiment, the bonding is aided by a material (e.g., a suitable bonding or adhesive material) applied to an alignment surface of the donor die 102 and/or target die 104 or provided to a gap between the donor die 102 and the target die 104 (e.g., in the form of gas or liquid). In some embodiments, physical contact between the donor die 102 and the target die 104 may include bonding, such as through a bonding wavefront generated by contact (or atomic level proximity), such as of a surface prepared for hydrogen bonding.

As shown in Figure 1B, the donor die 102 and the target die 104 may be annealed after contact as depicted by the wavy lines (while wavy lines are shown here at both the donor die 102 and the target die 104, the annealing agent need not be provided at both the donor die 102 and the target die 102 nor needs to be applied in the direction(s) shown). Annealing may be or include heat annealing, electrical annealing, electrostatic processes, etc. In some embodiments, annealing may include annealing of in-plane (or prominent) regions that are bonded and/or annealing of one or more recessed areas which may increase the volume of fill in a recess area (such as through thermal expansion, capillary force, etc.) and may cause physical contact and bonding of areas previously not in contact. As shown in Figure 1C, annealing may cause physical or chemical changes, such as in the one or more electrically active areas 106 of the donor die 102 or in the one or more electrically active areas 108 of the target die 104, which may cause or improve physical contact or electrical contact between an electrically active area 106 and an electrically active area 108. Annealing may therefore produce or enhance electrical connectivity between elements of the donor die 102 and the target die 104 (e.g., integration). This electrical connectivity may occur even if an electrically active area 106 and an electrically active area 108 differ-for example, have different recessed depths, are made up of different materials, have different dimensions, etc. In an embodiment, the prior bonding described with respect to Figure 1A may be temporary during one or more portions of the annealing process, wherein the annealing process forms tight connections between donor die 102 and the target die 104. In an embodiment, the annealing may occur in the system where the bonding occurs. In an embodiment, the annealing may occur in a separate system from the system in which the bonding occurs, e.g., the donor and target dies are transported out of the bonding system into an annealing system which can include one or more heating elements (e.g., one or more electrical heating elements, one or more elements to provide radiation heating, etc.) to provide the heat for the annealing.

Once the donor die 102 and the target die 104 are bonded, the carrier structure 114 may be removed as shown in Figure 1B. Additionally or alternatively, the carrier structure 116 may be removed then as well. Alternatively, once the donor die 102 and the target die 104 are annealed, the carrier structure 116 may be removed as shown in Figure 1C. Additionally or alternatively, the carrier structure 114 may be removed then as well.

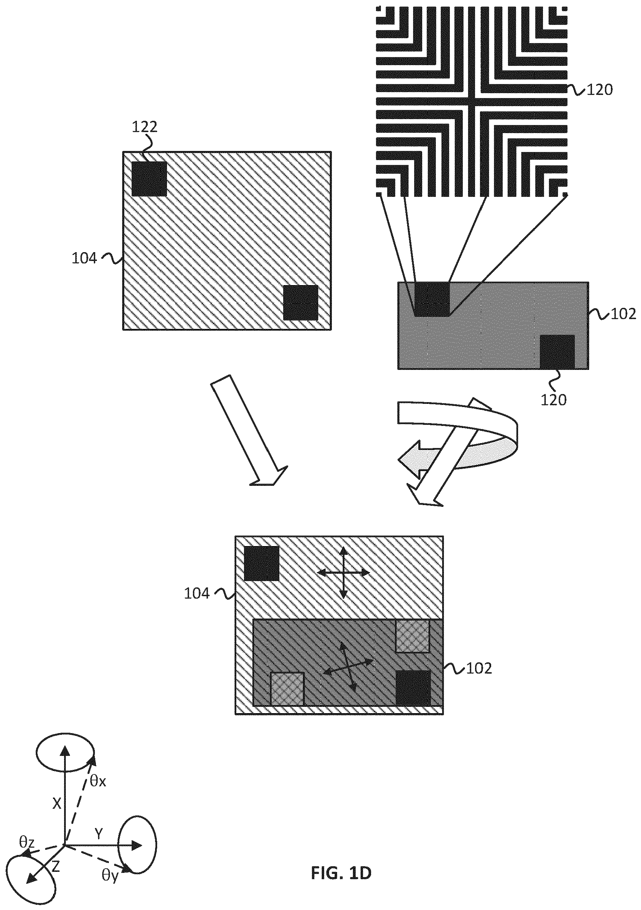

Figure 1D depicts a plan view of an example die bonding method according to this disclosure. As shown in Figure 1D, the donor die 102 and the target die 104 may have one or more alignment marks along the X-Y plane to facilitate alignment of the die as a whole. Alignment marks in the X-Y plane of a die (e.g., one or more alignment marks 120 on the donor die 102 or one or more alignment marks 122 on the target die 104) may reduce the area available for circuitry. One or more alignment marks may be placed in a waste area, such as an area between chips, which may then be destroyed (e.g., removed) during dicing. Dicing herein refers to mechanical separation of areas of a substrate (e.g., a unit of manufacture) into smaller areas (e.g., dies or chips) which may contain one or more units of operation (e.g., a logic device, a memory unit, etc.). Dicing may operate using any appropriate method-for example, scribing and breaking, mechanical sawing, laser cutting, etc.-and may destroy (e.g., grind to powder or otherwise render inoperable for circuitry placement) a non-zero linewidth portion of the substrate volume when separating die. Alignment marks may be additively or substractively fabricated, such as by etching or deposition in the Z-direction. Alignment marks 120 and 122 may be the same or different. Alignment marks 120 and 122 may be a multi-directional alignment mark, i.e., capable of determining alignment in more than one direction, such as a bi-direction alignment mark, an example of which is shown as mark 120 in Figure 1D. The alignment mark 120 and/or alignment mark 122 may be a fine alignment mark, such as for alignment in the $\mu$m scale. The alignment mark 120 may be located on the donor die 102 while the target die 104 may have an alignment mark 122 located in a waste area, or vice versa. Alternatively or additionally, one or more electrically active and/or doped areas of the donor die 102 or one or more electrically active and/or doped areas of the target die 104 (not shown in Figure 1D) or other surface features may function as a reference for alignment (e.g., an alignment mark) of the donor die 102 and/or the target die 104.

The donor die 102 and the target die 104 may be aligned in up to three dimensions before or during contact between the donor die 102 and the target die 104. For example, the donor die 102 or the target die 104 may be positioned in the x-y plane as the donor die 102 in the target die 104 are contacted. The donor die 102 or the target die 104 may be positioned by operation of a die actuator or other die-scale elements, such as by piezoelectric stepper elements, or by operation of a chuck or other carrier structure-scale elements, such as by a motor or other actuator. The position of the donor die 102 or the target die 104 may be adjusted with respect to up to six degrees of freedom. For example, given an origin point at a central part of the donor die 102, the donor die 102 may be positioned by movement along the X axis (e.g., in a positive or negative X direction), along the Y-axis (e.g. in a positive or negative Y direction), along the Z-axis (e.g., in a positive or negative Z direction). The donor die 102 may also be positioned rotationally with respect to each of those axes-e.g., rotated with respect to the X-axis, rotated with respect to the Y-axis, rotated with respect to the Z-axis. That is, the donor die 102 may be positioned by free movement in space accounted for by six different types of movement (where the movements listed above are provided as examples but where the movements may be described by other axes). Of course, the target die 104 may be positioned alone or combined with positioning of the donor die 102. Positioning or adjustment of position herein, unless the context otherwise requires, includes displacement, rotation or any combination thereof.

Distortions (e.g., errors in placement) of the donor die 102 and/or the target die 104 or one or more substrates containing the donor die 102 or the target die 104 may be corrected in up to three dimensions before or after contact between the donor die 102 and the target die 104. For example, the donor die 102 or the target die 104 may have one or more stress features induced, in a buried layer of the die, in a top layer of the die, etc., which may cause a volumetric change in the die. The volumetric change may cause a corresponding change in location in one or more surface features of the die (e.g., the donor die 102 or the target die 104). In some embodiments, the volumetric change may be a volumetric increase. In some embodiments, the volumetric change may be a decrease. In some embodiments, multiple stress features may be applied, such as in a pattern of stress features. In some embodiments, the change in location of the one or more surface features may be additive, such as increase as the number of stress features increases across a die or substrate surface.

The position of features on the donor die 102 or the target die 104 may be adjusted with respect to up to six degrees of freedom. For example, given an origin point at a central part of the donor die 102, the position of features of the donor die 102 may be corrected by application of stress features along the X-direction, along the Y-direction, and along the Z-direction (such as by a volumetric increase out of the plane of fabrication). The donor die 102 may also be corrected rotationally with respect to each of those directions-e.g., features may be rotated with respect to the X-axis, rotated with respect to the Y-axis, rotated with respect to the Z-axis. That is, the features of the donor die 102 may be corrected by application of a pattern of stress features which may generate correction as an adjustment corresponding to free movement in space accounted for by six different types of movement (where the adjustments listed above are provided as examples but where the adjustments may be described by other axes or directions). Of course, the target die 104 may be corrected alone or combined with positioning of the donor die 102. Correction of feature position or adjustment of features position herein, unless the context otherwise requires, includes displacement, rotation or any combination thereof.

In some embodiments, the donor die 102 and the target die 104 may be measured with respect to a reference plane or structure (e.g., the X-Y plane), including with respect to the same reference plane or structure, but the donor die 102 or the target die 104 may be flipped (before or after measurement) so that the fabrication surface of the donor die 102 and the fabrication surface of the target die 104 may be bonded (see, e.g., the bottom diagram of Figure 1D). The one or more alignment marks (e.g., the alignment marks 120 and 122) may be on the fabrication surface of the donor die 102 and the target die 104, respectively. In some embodiments, the donor die 102 and/or target die may be corrected, or a distortion measured, with respect to planned feature locations of the donor die 102 and target die, respectively. In some embodiments, a distortion in the donor die 102 and/or target die may be determined based on measured locations of the donor die 102 and target die 104, respectively, or features thereof (e.g., surface features such as the electrically active areas 106 and/or doped areas 110 of the donor die 102 and/or the electrically active areas 108 and/or doped areas 112 of the target die 104). Once the donor die 102 or the target die 104 is flipped, one or more alignment mark may be rendered invisible (such as due to opacity of a die) to an alignment measurement tool. The alignment of the flipped die may therefore be performed based on previously measured positions of the die (e.g., of the one or more alignment marks of the die) with respect to a structure, such as the donor die 102 with respect to the carrier structure 114 or such as the target die 104 with respect to the carrier structure 116.

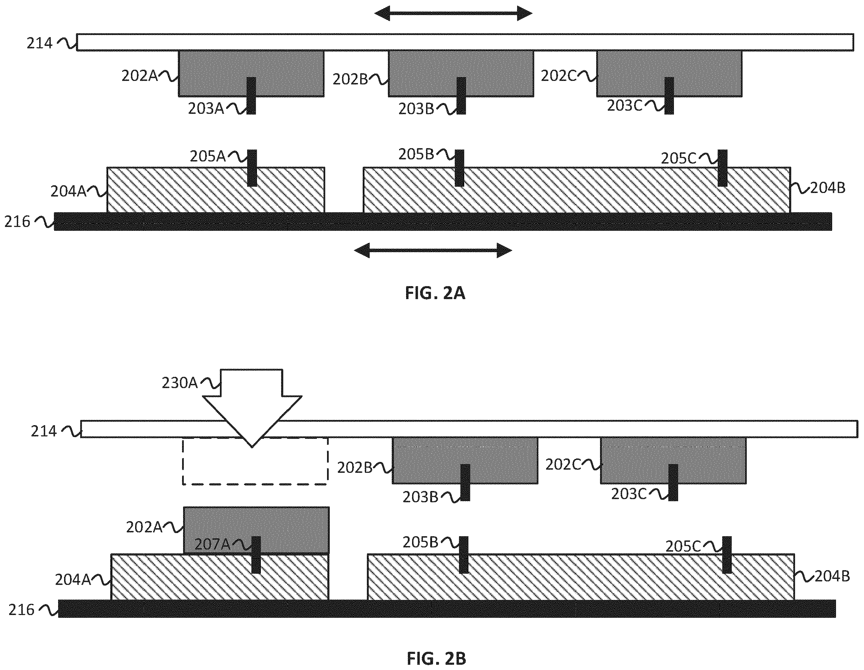

Figures 2A-2F are schematic diagrams illustrating an example method of die placement. Figures 2A-2F are described with reference to "donor die" (and "donor substrate" containing multiple "donor die") and "target die" (and "target substrate" containing multiple "target die"), which are relative descriptors and donor die may instead be target die and vice versa. Figures 2A-2F are described with respect to donor die and target die, which may be in a donor substrate or target substrate, where a "substrate" may contain multiple "die", including un-diced (e.g., unseparated) die in the form of all or part of a semiconductor substrate. Figure 2A-2F are cross-sectional views of die placement of donor dies (e.g., donor die 202A, 202B, 202C) on target dies (e.g., target die 204A and target die 204B). In some embodiments, multiple steps which are depicted as occurring substantially simultaneously in Figures 2A-2F may be performed sequentially. In some embodiments, multiple steps which are depicted as occurring sequentially in Figures 2A-2F may be performed substantially simultaneously. In some embodiments, multiple donor dies may be aligned or placed on their respective target dies substantially simultaneously, including donor dies which are proximate (including adjacent) or distant (e.g., non-adjacent but within the same target substrate). In some embodiments, steps may be performed in a different order.

Figure 2A is a cross-sectional view of donor dies 202A-202C which are to be placed on target dies 204A-204B. The donor dies 202A-202C are supported by a carrier structure 214. The donor dies 202A-202C may be adhered to the carrier structure 214 in any appropriate manner, such as by vacuum adhesion, electrostatic adhesion, intermolecular adhesion, mechanical interlocking, surface reaction, static friction, gravitational force, etc. The donor dies 202A-202C may be adhered to the carrier structure 214 by use of an adhesive (e.g., glue), such as an organic, polymer glue. The carrier structure 214 may be a transparent substrate, such as glass, sapphire, polymer, etc. substrate. The donor dies 202A-202C may be placed on the carrier structure 214 by any appropriate method, such as by a pick and place tool. The carrier structure 214 may be supported by a chuck or any other appropriate support structure.

The target dies 204A-204B are supported by a support structure 216. In an embodiment, the target dies 204A-204B may be part of an undiced or partially diced target substrate. The target dies 204A-204B may be adhered to the support structure 216 in any appropriate manner, such as by vacuum adhesion, electrostatic adhesion, intermolecular adhesion, mechanical interlocking, surface reaction, static friction, gravitational force, etc. The target dies 204A-204B may be adhered to the support structure 216 by use of an adhesive (e.g., glue), such as an organic, polymer glue. In an embodiment, where, for example, the target dies 204A-204B are diced die, the support structure may be a carrier structure (e.g., like carrier structure 214) and may be a transparent substrate, such as glass, sapphire, polymer, etc. substrate. The target dies 204A-204B may be placed on the support structure 216 by any appropriate method, such as by a pick and place tool. The support structure 216 may be, or may be supported by, a chuck or any other appropriate structure.

The donor dies 202A-202C and the target dies 204A-204B may be corrected-e.g., by application of a pattern of stress features-before alignment, including before the donor dies (e.g., the donor dies 202A-202C) and/or the target dies (e.g., the target dies 204A and 204B) are placed on the support structure 214 and/or the support structure 216 or while the donor dies (e.g., the donor dies 202A-202C) and/or the target dies (e.g., the target dies 204A and 204B) are held by the support structure 214 and/or the support structure 216. The donor dies 202A-202C and the target dies 204A-204B may be corrected by application of a pattern of stress features which releases stress, induces stress, causes one or more volumetric change, causes changes in locations of features of the die, etc.

The donor dies 202A-202C and the target dies 204A-204B may be aligned with one another at alignment points 203A and 205A (for donor die 202A and target die 204A), alignment points 203B and 205B (for donor die 202B and target die 204B), and alignment points 203C and 205C (for donor die 202C and target die 204B). In some embodiments, multiple donor die may be placed on a single target die, and vice versa, such as depending on integration goals. The alignment points 203A-203C are depicted for the donor dies 202A-202C, while the alignment points 205A-205C are depicted for the target dies 204A-204B. These alignment points are provided for ease of description only and need not be physical features. There may be multiple alignment points per die. The alignment points may be alignment marks (for example, the alignment marks of Figure 1D), die edges, die corners, other features on edges or surfaces of die. The alignment points may be used to align donor and target die, such as by measurement of the locations of various alignment points and then adjustment of the position of the donor and/or target die, such as by movement of a carrier structure supporting the die, to align an alignment point of the donor die with an alignment point of the target die (or vice versa). The alignment points may be aligned directly to one another (e.g., as depicted in Figures 2A-2F). In some embodiments, the alignment points may be aligned relative to one another (e.g., in a predetermined relationship, such as separated by a vector), such as depicted in the bottom of Figure 1D, where the alignment marks are non-overlapping.

In Figure 2A, the carrier structure 214 (and/or the structure 216) may be positioned, such as in the X-Y plane, in order to align the alignment point 203A of the donor die 202A with the alignment point 205A of the target die 204A.

In Figure 2B, the donor die 202A may be released from the carrier structure 214 by any appropriate mechanism, such as release mechanism 230A. The donor die 202A meets the target die 204A at alignment point 207A. The release of the donor die 202A may be facilitated by gravity, by electrostatic forces, by physical forces, etc. The alignment of the donor die 202A and the target die 204A at the alignment point 207A (which represents a combination of the alignment point 203A and the alignment point 205A of Figure 2A) may be assisted by any appropriate alignment mechanism, including self-alignment (e.g., attraction of one area of the donor die 202A to a corresponding area of the target die 204A). In an embodiment, the release occurs while donor die 202A is in (at least partial) contact with target die 204A. In an embodiment, the release occurs before donor die 202A is in contact with the target die 204A.

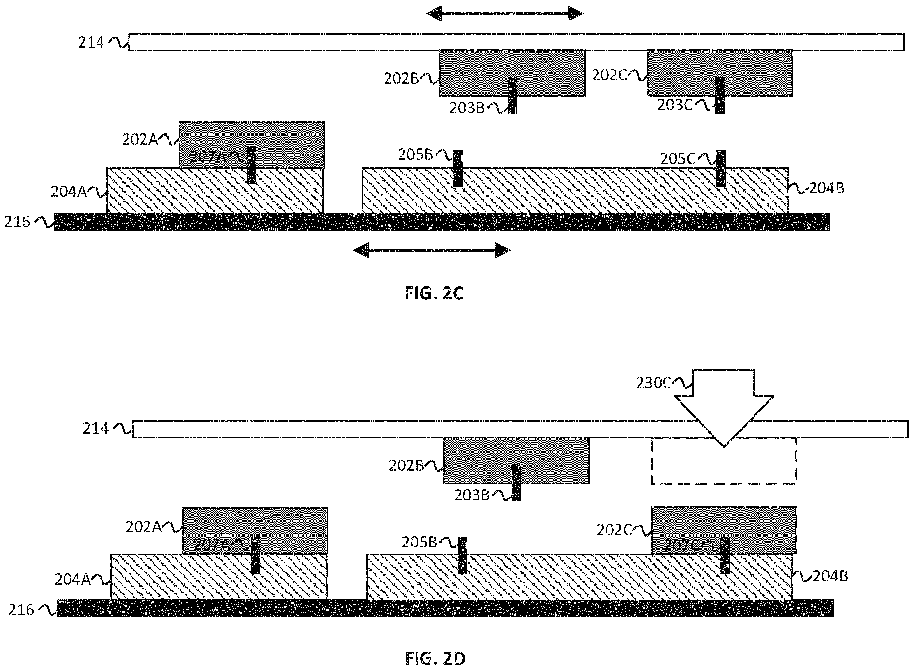

In Figure 2C, the carrier structure 214 and alternately or additionally the structure 216 may be moved to bring another donor die (e.g., the donor die 202C) into alignment with another target die (e.g., the target die 204B). The alignment of alignment point 203C (of donor die 202C) and alignment point 205C (of target die 204B) may be based on measurements of the relative positions of the alignment points (such as using an alignment mark or feature on a die or carrier structure, using a position of an alignment point on another donor or target die, etc.). The alignment of alignment point 203C (of donor die 202C) and alignment point 205C (of target die 204B) may be based on one or more substantially simultaneous measurement of the relative positions of an alignment point, such as using an alignment mark or feature of a die or carrier structure, using an alignment target or feature of another donor or target die, etc. Although alignment of only one donor die (e.g., the donor die 202C) and target die (e.g., the target die 204B) is depicted, alignment of one or more sets of donor and target dies may occur substantially simultaneously, such as if for a given relative position of the carrier structure 214 and the support structure 216 the alignment points of multiple donor dies are aligned with the alignment points of multiple target dies. However, the ability to place multiple donor dies substantially simultaneously may depend on the placement of the donor dies on the carrier structure 214 and the ability of the release mechanism to release multiple donor dies.

In Figure 2D, the donor die 202C may be released from the carrier structure 214 by any appropriate mechanism, such as release mechanism 230C. The donor die 202C meets the target die 204B at alignment point 207C. The release of the donor die 202C may be facilitated by gravity, by electrostatic forces, by physical forces, etc. The alignment of the donor die 202C and the target die 204B at the alignment point 207C (which represents a combination of the alignment point 203C and the alignment point 205C of Figure 2A) may be assisted by any appropriate alignment mechanism, including self-alignment. In an embodiment, the release occurs while donor die 202B is in (at least partial) contact with target die 204B. In an embodiment, the release occurs before donor die 202B is in contact with the target die 204B.

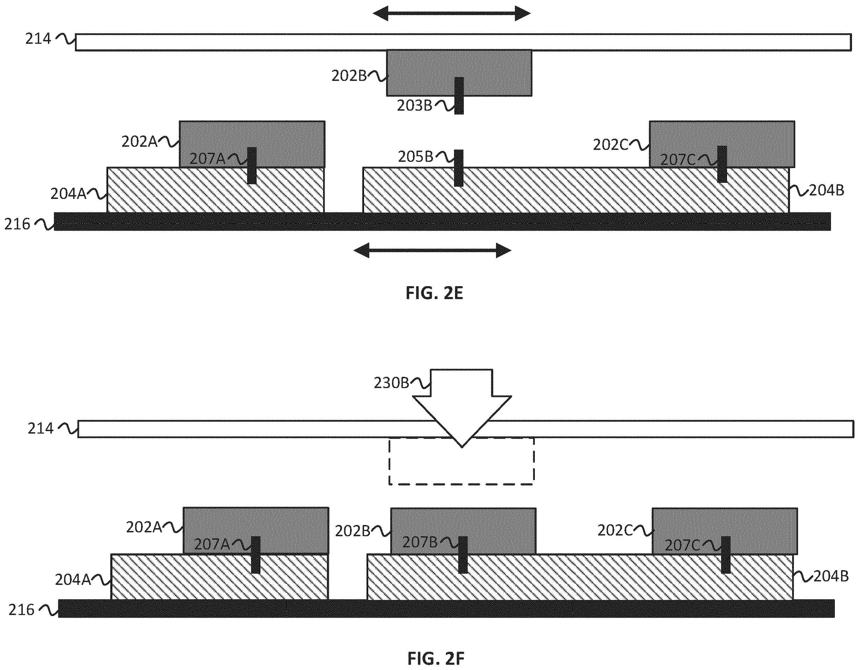

In Figure 2E, the carrier structure 214 and alternately or additionally the structure 216 may be moved to bring another donor die (e.g., the donor die 202B) into alignment with another target die (e.g., the target die 204B). The alignment of alignment point 203B (of donor die 202B) and alignment point 205B (of target die 204B) may be based on previous measurements of the relative positions of the alignment points (such as using an alignment mark on a die or carrier structure, using an alignment point on another donor or target die, etc.). The alignment of alignment point 203B (of donor die 202B) and alignment point 205B (of target die 204B) may be based on one or more substantially simultaneous measurements of the relative positions of an alignment point, such as using an alignment mark or feature of a die or carrier structure, using an alignment target or feature of another donor or target die, etc. As depicted, the donor die 202B and the donor die 202C are aligned to the same target die (e.g., the target die 204B). In some embodiments, the donor die are placed on the target die in a substantially one-to-one relationship (e.g., as depicted for the donor die 202A and the target die 204A). In some embodiments, multiple donor die (or target die) may be placed on the same target die (or donor die). In some embodiments, multiple donor die (or target die) may be placed on un-diced (e.g., unseparated) target die (or donor die), such as all or part of a substrate containing target die (or donor die). In some embodiments, a donor die may be placed on a target die that has multiple die, including stacked (e.g., bonded) die, such as in a three layer die bonding stack.

In Figure 2F, the donor die 202B may be released from the carrier structure 214 by any appropriate mechanism, such as release mechanism 230B. The donor die 202B meets the target die 204B at alignment point 207B. The release of the donor die 202B may be facilitated by gravity, by electrostatic forces, by physical forces, etc. The alignment of the donor die 202B and the target die 204B at the alignment point 207B (which represents a combination of the alignment point 203B and the alignment point 205B of Figure 2A) may be assisted by any appropriate alignment mechanism, including self-alignment. In an embodiment, the release occurs while donor die 202B is in (at least partial) contact with target die 204B. In an embodiment, the release occurs before donor die 202B is in contact with the target die 204B.

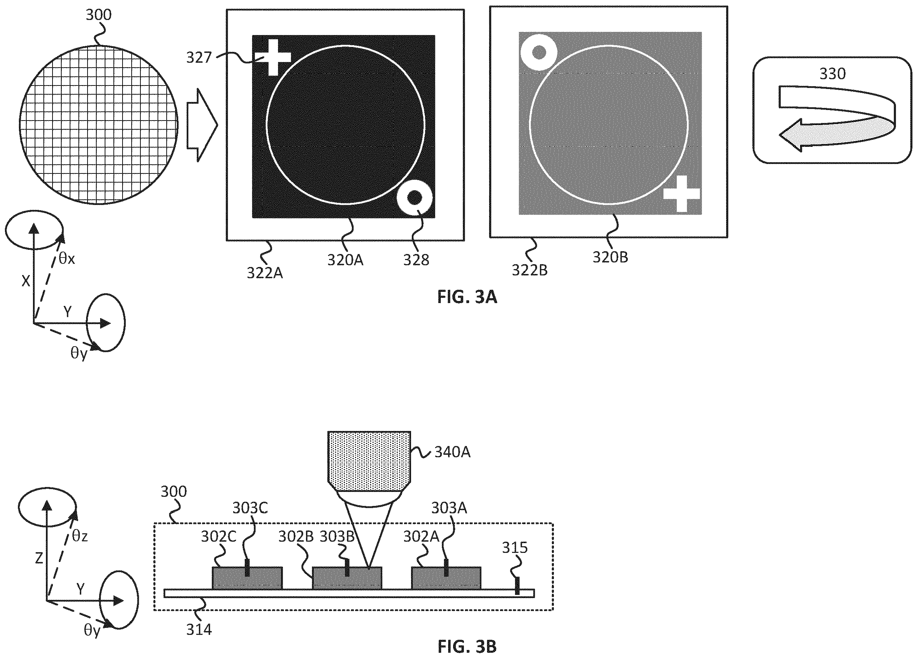

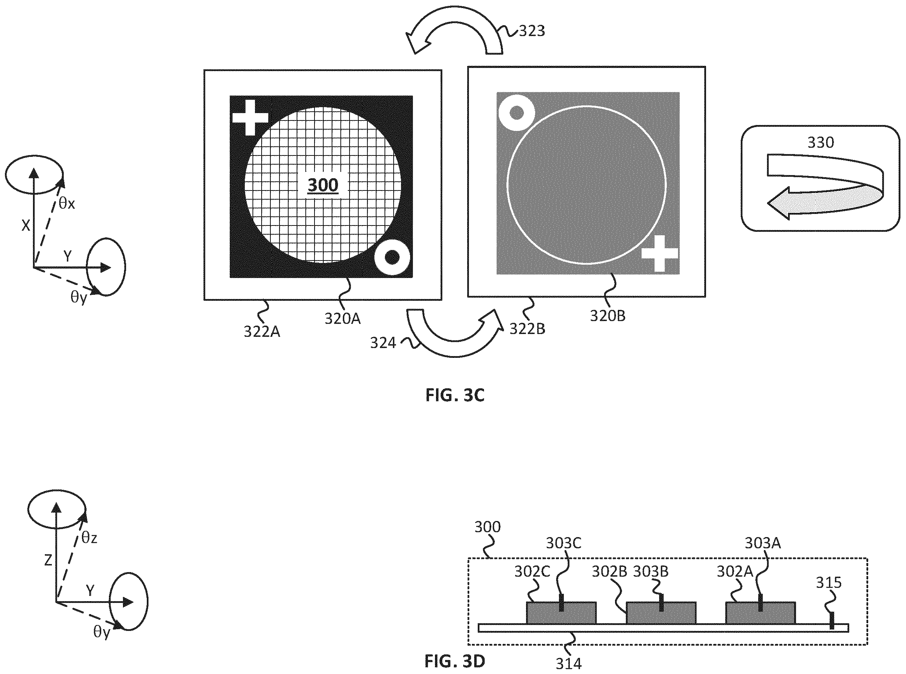

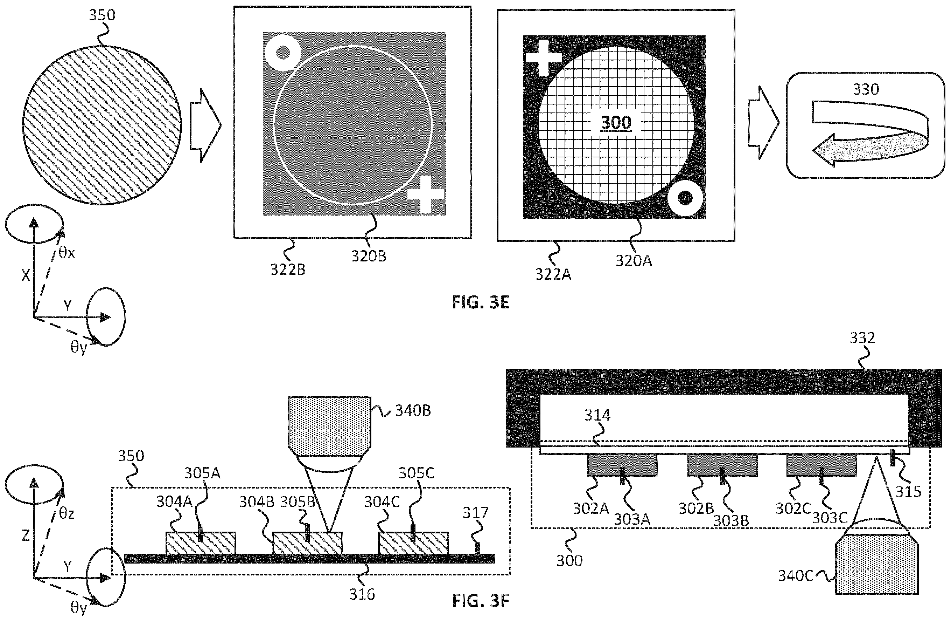

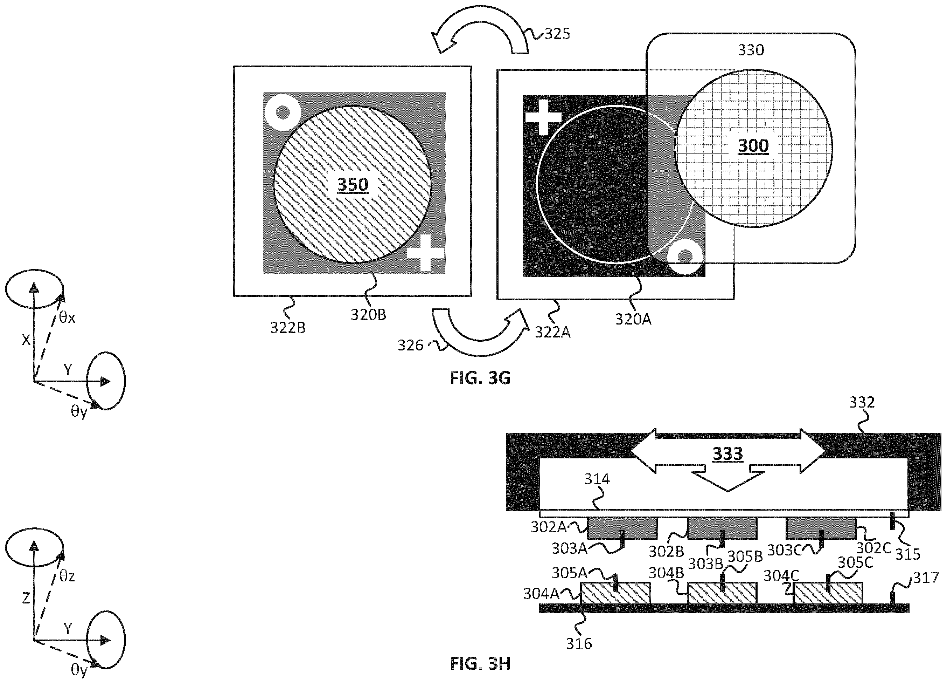

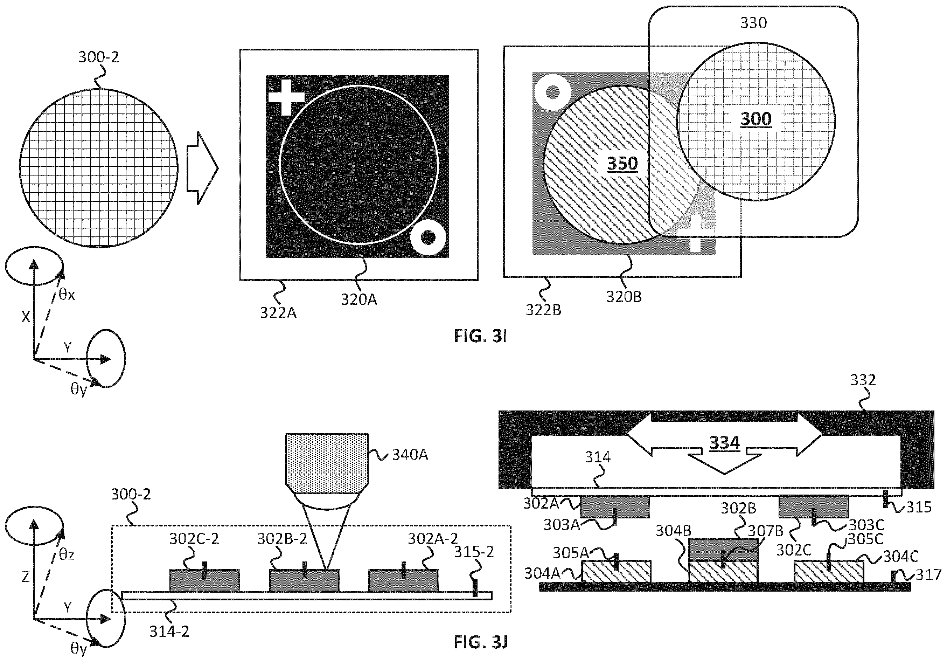

Figures 3A-3J are schematic diagrams illustrating portions of an example apparatus for die bonding. Figures 3A-3J are described with reference to "donor die" and "target die", which are relative descriptors as used herein and donor die may instead be target die and vice versa. Each of Figures 3A, 3C, 3E, 3G, and 3I is a plane view of an apparatus during placement of donor die on the target die. Each of Figures 3B, 3D, 3F, 3H, and 3J is a cross-sectional view of the apparatus during placement of donor die on the target die. The views of the apparatus in various figures represent different operations of the apparatus, but operations depicted as occurring in different figures may occur at different times or may instead be performed simultaneously and operations depicted as occurring in the same figure may instead be performed individually or at different times. A donor substrate 300 and a target substrate 350 are depicted as circular, but may instead be any appropriate shape, including rectangular, square, etc. The donor substrate 300 (and target substrate 350) may be the substrate in or on which the donor die (target die) have been formed. The donor substrate 300 (target substrate 350) may be a "reconstructed wafer", in which donor die (target die) (or other disparate portions of a semiconductor substrate) are arranged or supported on a carrier structure, e.g., to be in position suitable for die bonding. So, the donor substrate 300 (target substrate 350) may be a carrier structure and donor die (target die), where the donor die (target die) may be held (e.g., adhered) to the carrier structure by any appropriate method, such as by gravitational force, by adhesive (e.g., organic, polymer adhesive), by electrostatic forces, etc. The donor substrate 300 (target substrate 350) may contain previously tested donor die (target die), such as donor die (target die) that passed a failure analysis or other post fabrication testing. The donor substrate 300 (target substrate 350) may contain donor die (target die) from the same or different semiconductor substrates (e.g., fabrication substrates), including donor die (target die) of different types, different dimensions, etc. The donor substrate 300 (target substrate 350) may have donor die (target die) placed on the donor substrate 300 (target substrate 350) by any appropriate method, such as a pick and place tool. The donor substrate 300 (target substrate 350) may be supported, such as by a carrier structure, vacuum chuck, electrostatic chuck, etc., by either a top side (e.g., fabrication face) or backside (e.g., bulk substrate or carrier structure face) or by different faces at various points. The donor substrate 300 or donor die (target substrate 350 or target die) may have fabricated devices on multiple faces, such as through silicon vias (TSVs), contact pads, etc., such that both a top side and backside are fabrication faces.

In Figure 3A, the donor substrate 300 may be placed on a substrate chuck 320A. The substrate chuck 320A may be an appropriate substrate chuck, such as to support the donor substrate 300 in the form of a semiconductor substrate or a carrier structure of the donor substrate 300. The substrate chuck 320A may be supported by a support structure 322A. The support structure 322A may be a moveable support structure, which may move in the X-Y plane, such as from a first position where the substrate chuck 320A receives the donor substrate 300 to a second position where the donor substrate 300 may be subjected to metrology. The substrate chuck 320A may contain (e.g., support) one or more die actuators or other mechanical or electrical actuators which may move a donor die or the donor substrate 300 in one or more dimension, including in the X-Y plane, in the Z-direction, rotationally, etc. The substrate chuck 320A may have one or more alignment marks, such as to allow a camera or other measurement system to track the position of the substrate chuck 320A. The substrate chuck 320A may have multiple sets of alignment marks, such as coarse alignment marks and/or fine alignment marks. The substrate chuck 320A may move, such as by action of the support structure 322A, from one position to another, in free space, etc. The support structure 322A may be configured to move in multiple directions and in multiple scales (e.g., in a coarse step and a fine step), such as by multiple motors or steppers. The support structure 322A may be activated by a controller of the example apparatus-where the controller of the example apparatus (not depicted) may also control the placement of the donor substrate 300 on the substrate chuck 320A and other operations described herein.

The substrate chuck 320A may have a measurement point (or alignment point), such as identified by a cruciform measurement mark 327 and a round zero measurement mark 328, which are provided merely as examples and where any appropriate zero measurement mark may be used. The measurement point may be used to place the donor substrate 300 on the substrate chuck 320A, such as during movement of the substrate onto the chuck (for example, by insertion of the donor substrate by a substrate handler). The measurement point may be used to measure relative positions of the donor die of the donor substrate 300 once the donor substrate 300 is placed on the substrate chuck 320A. The placement of the donor die may be measured, such as with up to nm precision, with respect to the measurement point. The measurement of the position of the donor die after their placement may be obtained from any appropriate measurement system, such as optical microscopy, reflectometry, etc.

The locations of the donor die or features of the donor die may be corrected-e.g., by application of a pattern of stress features-based on measurements of the positions of the die and/or features of the die relative to the measurement point (e.g., the cruciform measurement mark 327 and/or the round zero measurement mark 328). The locations of the donor die or features of the donor die may be corrected based on measurement of a distortion of the positions of the die and/or features of the die based on a planned layout of the donor die or features of the donor die. The locations of the donor die or features of the donor die may be corrected based on measurement of a distortion of the positions of the die and/or features of the die based on a measurement of stress in the die or a substrate containing the die-for example, stress may be determined by interferometric measurement, optical beam imaging, electron beam imaging, etc. The locations of the donor die or features of the donor die may be corrected, and then the locations of the donor die or features of the donor die may be re-measured, including iteratively with multiple applications of a pattern of stress features, until the distortion and/or error in the locations of the donor die or features of the donor die is lower than a threshold. The correction of the donor die may take place when the donor die are located on the substrate chuck 320A, or at any other appropriate location, including before the donor die are loaded onto the substrate chuck 320A.

Figure 3A also depicts a further substrate chuck 320B on a support structure 322B. The substrate chuck 320B may be any appropriate substrate chuck, such as substantially identical to the substrate chuck 320A. The support structure 322B may be any appropriate support structure, such as substantially identical to the support structure 322A. In some embodiments, the substrate chuck 320B and the substrate chuck 320A may be substantially indistinguishable. In some embodiments, the support structure 322B and the support structure 322A may be substantially indistinguishable. Although two substrate chucks and two support structures are depicted, in some embodiments more or less substrate chucks and support structures may be present in the apparatus. Operations depicted as performed by the substrate chuck 320B (substrate chuck 320A) may instead or additionally be performed by any appropriate substrate chuck. Likewise, operations depicted as performed by the support structure 322B (support structure 322A) may instead or additionally be performed by any appropriate support structure.

Figure 3A also depicts flipper 330. The flipper 330 may be any appropriate apparatus which may flip a substrate (e.g., donor substrate 300), such as about the longitudinal axis or plane of the donor substrate 300 depicted in Figure 3A. The flipper 330 will be described in more detail in reference to Figures 3E and 3F.

In Figure 3B, a cross-sectional view of a donor substrate 300 is depicted. The donor substrate 300 comprises a carrier structure 314 which supports one or more donor die (e.g., donor die 302A-302C). The substrate may have one or more alignment points, such as alignment point 315, used to measure a relative position of the donor die 302A-302C with respect to the carrier structure. The donor die may have alignment points, such as alignment points 303A-303C for donor die 302A-302C, respectively. The alignment points are provided as schematic representations in these drawings for ease of description, and may be any appropriate alignment points, including alignment marks, fabricated features, edge features, etc., as previously described. While the donor substrate 300 is on a substrate chuck (e.g., the substrate chuck 320A of Figure 3A), the positions of the donor die (e.g., the donor die 302A-302C) are measured, such as by metrology tool 340A. The positions may be measured as absolute positions, relative positions, positions relative to other die, positions relative to an alignment point of the substrate, etc. The measured positions may be stored by a controller of the apparatus, such as for later positioning of the donor substrate 300. The metrology tool 340A may be a camera, including a still camera, a video camera, etc. The metrology tool 340A may be any appropriate tool for measurement of a position of a donor die, measurement of a position of an alignment point of the donor die, measurement of a position of alignment mark of the donor die, etc.

In Figure 3C, the donor substrate 300 is supported by the substrate chuck 320A, which is supported by the support structure 322A. Once the position of the donor dies are measured, the substrate chuck 320A may be moved, such as out of the measurement position. The support structure 322A may move (e.g., along direction 324) to the position of the support structure 322B, while the support structure 322B may move (e.g., along direction 323) to the position of the support structure 322A. The positions are provided as examples, and the support structures may move to different positions. For example, in some embodiments, the support structure 322B may move to a loading position, such as to receive a target substrate (e.g., the target substrate 350). The substrate chuck 320A may then occupy another position in the apparatus (e.g., a bonding position, a flipping position, etc.). The position the substrate chuck 320A moves to after measurement of the positions of the donor die (e.g., after the measurement depicted in Figure 3B) may be configured to allow the flipper 330 to accept the donor substrate 300 from the substrate chuck 320A.

In Figure 3D, the movement of the donor substrate 300 to a position other than the measurement position of Figure 3B is depicted. The movement may correspond to the movement of the donor substrate 300 in the direction 324, such as by movement of the support structure 322A, of Figure 3C. This figure is provided to show continuity of the die bonding process in both plane and cross-sectional views, but may occur substantially simultaneously with the process depicted in Figure 3C or Figure 3E, where, as previously described, steps which are depicted as occurring separately, including sequentially, may be performed substantially simultaneously.

In Figure 3E, the target substrate 350 may be placed on a substrate chuck 320B. The substrate chuck 320B may be an appropriate substrate chuck, as previously described. The substrate chuck may be supported by a support structure 322B, which may be any appropriate support structure, as previously described.

In Figure 3E, the donor substrate 300 may be transferred to the flipper 330. The flipper 330 may accept (e.g., take) the donor substrate from the substrate chuck 320A, such as by use of edge clamps, vacuum clamps, finger prongs, etc. The flipper 330 may hold the donor substrate by one or more edges (e.g., one or more edges of the carrier structure 314) or one or more sides (for example, a backside of the carrier structure 314 which does not support the donor die). The flipper 330 may rotate the donor substrate 300 upside down (e.g., with respect to the direction of the gravitational force). The flipper 330 may hold the donor substrate 300 upside down (e.g., opposite to) with respect to the X-Y plane which it previously occupied-or in any other appropriate direction. The flipper 330 may hold the donor substrate 300 or place the donor substrate 300 into a support structure, such that the donor substrate 300 faces the plane of the target substrate 350. The flipper 330 may rotate or displace the donor substrate 300 in the X-Y plane, as well as displace or rotate the donor substrate 300 out of the X-Y plane. The flipper 330 may be any appropriate rotational or translational apparatus.

In Figure 3F, a cross-sectional view of the target substrate 350 is depicted. The target substrate 350 comprises a carrier structure 316 which supports one or more target dies (e.g., target die 304A-304C). The substrate may have one or more alignment points, such as alignment point 317. The target die may have alignment points, such as alignment points 305A-305C for target die 304A-304C, respectively. The alignment points are provided as schematic representations in these drawings for ease of description, and may be any appropriate alignment points, including alignment marks, fabricated features, edge features, etc., as previously described. While the target substrate 350 is on the substrate chuck (e.g., the substrate chuck 320B of Figure 3E), the positions of the one or more target dies (e.g., the target die 304A-304C) are measured, such as by metrology tool 340B. The metrology tool 340B may be the same as the metrology tool 340A used to measure the positions of the one or more donor dies (e.g., the donor die 302A-302C of Figure 3B) or a different metrology tool. The metrology tool 340B may measure a different number of positions, substantially different positions (e.g., arranged differently on the target substrate 300 than the positions on the donor substrate 300 as measured by the metrology tool 340A), different positions relative to dies (e.g., the donor die 302A-302C versus the target die 304A-304C), etc. than the metrology tool 340A. The positions may be measured as absolute positions, relative positions, positions relative to other die, positions relative to an alignment point of the substrate, etc. The measured positions may be stored by a controller of the apparatus, such as for later positioning of the target substrate 350. The metrology tool 340B may be a camera, including a still camera, a video camera, etc. The metrology tool 340B may be any appropriate tool for measurement of a position of a donor die, measurement of a position of an alignment point of the donor die, measurement of a position of alignment mark of the donor die, etc. The target substrate 350 may experience deformation due to the holding by a substrate chuck, etc. The metrology tool 340B may also enable determination of deformation of the target substrate by measuring locations. A controller may determine the deformation of the target substrate 350 based on those measured locations (e.g., from curve fitting, using a physical deformation model, etc.).

The locations of the target die or features of the target die may be corrected-e.g., by application of a pattern of stress features-based on measurements of the positions of the die and/or features of the die relative to the measurement point (e.g., alignment points 317). The locations of the target die or features of the target die may be corrected based on measurement of a distortion of the positions of the die and/or features of the die based on a planned layout of the target die or features of the target die. The locations of the target die or features of the target die may be corrected based on measurements of the locations of the donor die or features of the donor die, such as obtained as previously described in reference to Figure 3A. In some embodiments, the locations of the donor die and/or features of the donor die and the locations of the target die and/or features of the target die may be co-adjusted, such as so that a distortion in the donor die matches a distortion in the target die so that the donor die and target die may be aligned even if not distortion free. The locations of the target die or features of the target die may be corrected based on measurement of a distortion of the positions of the die and/or features of the die based on a measurement of stress in the die or a substrate containing the die-for example, stress may be determined by interferometric measurement, optical beam imaging, electron beam imaging, etc. The locations of the target die or features of the target die may be corrected, and then the locations of the target die or features of the target die may be re-measured, including iteratively with multiple applications of a pattern of stress features, until the distortion and/or error in the locations of the target die or features of the target die is lower than a threshold. The correction of the target die may take place when the target die are located on the substrate chuck 320A, or at any other appropriate location, including before the target die are loaded onto the substrate chuck 320B.

In Figure 3F, the donor substrate 300 is supported by a bonding support structure 332. The bonding support structure 332 may be part of the flipper 330 (of Figure 3E) or the donor substrate 300 may be placed into the bonding support structure 332 by the flipper 330. The bonding support structure 332 may hold the donor substrate 300 opposite to a plane of the target substrate 350. The bonding support structure 332 may hold the donor substrate by the carrier structure 314, including by one or more edges of the carrier structure 314. While in the bonding support structure 332, the position of the donor substrate 300 may be measured, such as by metrology tool 340C, to enable, for example, relative positioning between the donor substrate 300 and the target substrate 350. The metrology tool 340C may be any appropriate metrology tool. The metrology tool 340C may measure locations of the donor die (e.g., the donor die 302A-302C), locations of the alignment point 315, etc. The metrology tool 340C may measure significantly fewer locations than the metrology tool 340A or 340B, and the controller may determine the position of the target substrate 350 based on those fewer locations (e.g., from curve fitting, using physical deformation models, etc.). The controller may determine updated positions for the donor die (e.g., the donor die 302A-302C) based on a combination of the measured locations of the donor die 302A-302C (such as from Figure 3B) and the measured position of the donor substrate 300. The donor substrate 300 may experience deformation due to holding by a substrate chuck, the movement of the flipper 330, suspension from the bonding support structure 332, etc. The metrology tool 340C may also enable determination of deformation of the donor substrate by measuring locations. As noted above, the metrology tool 340C may measure significantly fewer locations than the metrology tools 340A and 340B, and the controller may determine the deformation of the donor substrate 300 based on those fewer locations (e.g., from curve fitting, using a physical deformation model, etc.) than those measured by the metrology tool 340A on the donor substrate 300 or by metrology tool 340B on the target substrate 350.

In Figure 3G, the target substrate 350 is supported by the substrate chuck 320B, which is supported by the support structure 322B. Once the position of the target dies are measured, the substrate chuck 320B may be moved, such as to align with the donor substrate 300 supported by the flipper (e.g., supported by the bonding support structure 332 of Figure 3F). The support structure 322B may move (e.g., along direction 326) to the position of the support structure 322A, while the support structure 322A may move (e.g., along direction 325) to the position of the support structure 322B. The positions are provided as examples, and the support structures may move to different positions. For example, in some embodiments, the support structure 322A may move to a loading position, such as to receive an additional target substrate (e.g., the target substrate 350). The substrate chuck 320B may then occupy another position in the apparatus (e.g., a bonding position). The position the substrate chuck 320B moves to after measurement of the positions of the target die (e.g., after the measurement depicted in Figure 3F) may be configured to place a donor die of the donor substrate 300 onto the target die of the target substrate 350. The substrate chuck 320B may be aligned with the donor substrate 300 in the flipper 330, which may be held above the plane of the substrate chuck 320B (as depicted in Figure 3G for a top down view in which the donor substrate 300 is at least partially above the plane of the substrate chuck 320B (e.g., obscuring the substrate chuck 320A).

In Figure 3H, the donor substrate 300 and the target substrate 350 are aligned. The donor substrate 300 may be aligned to the target substrate 350 by movement of the bonding support structure 332, such as in any of the directions or orientations 333. The target substrate 350 may be aligned with the donor substrate 300 by movement of a substrate chuck (e.g., the substrate chuck 320B of Figure 3G) or the support structure (e.g., the support structure 322B of Figure 3G). The donor substrate 300 and the target substrate 350 may be aligned to one another, including by both coarse and fine alignment, such as by alignment of the relative positions of one or more alignment point (e.g., the alignment point 315 of the donor substrate 300 and the alignment point 317 of the target substrate 350). In some embodiments, the donor substrate 300 and the target substrate 350 may be aligned, such as by coarse alignment. In some embodiments, once the donor substrate 300 and the target substrate 350 are aligned, one or more donor die of the donor substrate 300 may be aligned with one or more target die of the target substrate 350. In Figure 3H, the alignment of the donor die 302B with the target die 304B (e.g., of the alignment point 303B of donor die 302B with the alignment point 305B of target die 304B) is depicted. Once a donor die is aligned with a target die, that donor die may be placed on the target die, by any appropriate method, such as die actuator activation, gravitational acceleration, electrostatic actuation, etc.

In Figure 3I, an additional donor substrate (e.g., donor substrate 300-2 having a carrier structure 314-2) is placed on the substrate chuck 320A for additional placement of donor dies on target dies. In some embodiments, the additional donor substrate may be placed on the substrate chuck 320A after the substrate of the previous donor substrate is removed from the substrate chuck 320A-for example, if the substrate of a donor substrate is removed from the flipper 330 and re-placed on the substrate chuck 320A. In some embodiments, the previous donor substrate may be removed from the flipper 330 without recourse to the substrate chuck 320A, such as by removal from the flipper to an additional substrate chuck (not depicted) or any other appropriate removal procedure. The additional donor substrate may be placed on the substrate chuck 320A after the previous donor substrate is accepted by the flipper 330 or at any time when the substrate chuck 320A (or another substrate chuck) is free. The additional donor substrate (e.g., the donor substrate 300-2) may be substantially identical to or different from the previous donor substrate (e.g., the donor substrate 300). The processing of the donor substrate 300-2 by placement of the donor dies on target dies may proceed as previously described in relation to Figures 3A-3H, such as by placement on an additional target substrate (not depicted). The donor substrate 300-2 may be placed on the substrate chuck 320A while the donor dies of the donor substrate 300 are placed on the target dies of the target substrate 350, such as substantially simultaneously.

In Figure 3J, the positions of the donor die (e.g., the donor die 302A-2 to 302C-2) and/or of mark 315-2 are measured, as previously described in relation to Figure 3B.

In Figure 3J, additional donor die of the donor substrate 300 are placed on the target die of the target substrate 350. The position of the donor substrate 300, the target substrate 350, or a combination thereof may be adjusted to align an additional donor die of the donor substrate 300 with a target die of the target substrate 350. As depicted, the donor substrate 300 is positioned (such as by movement in the directions or orientations 334) to align the alignment point 303A of the donor die 302A with the alignment point 305A of the target die 304A. The donor die 302A may then be placed on the target die 304A by any appropriate method, such as previously described. The donor die 302B is depicted as bonded to the target die 304B, subsequent to their alignment at alignment point 307B in Figure 3H. As will be realized, the various steps of Figures 3A-H can be repeated as appropriate to bond multiple dies and process multiple donor and target substrates.

In order to improve accuracy in the die bonding process (e.g., including individual die to individual die bonding, substrate to substrate bonding, individual die to substrate bonding) that includes alignment of patterned die (or substrates), the patterned substrate may be inspected and one or more parameters of the patterned substrate measured. The one or more parameters may include locations-relative or absolute-for one or more features on the surface (or near the surface, such as at an optically transparent depth). The measurement may be performed on the patterned die before or after dicing, including in applications where the die is not diced or not diced until after die bonding. The measurement may be performed on the die, the substrate, or a subsection thereof. There are various techniques for making measurements of the structures formed in the patterning process, including the use of a scanning electron microscope, image-based measurement or inspection tools and/or various specialized tools. While discussion in this application will consider an embodiment of a metrology process and correction configured to operate in tandem with die bonding, the embodiments herein are equally applicable to other metrology processes and/or operations, such as a metrology process and/or a specifically designed target (e.g., calibration die, calibration substrate, etc.) to measure process parameters or aid in process control.

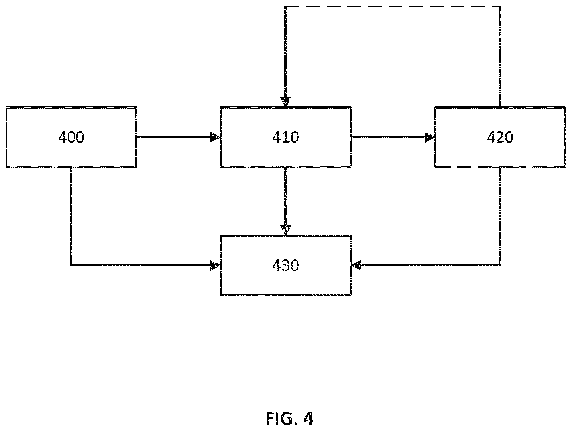

Figure 4 is a schematic diagram illustrating a relationship between metrology and a position modification system. Referring to Figure 4, a die processing, metrology, and patterned die modification system is shown. The system comprises a die processing system (e.g., a lithography tool, a nanoimprint lithography tool, an optical lithographic apparatus, an etch tool, a die bonding system, a die dicing system, any other system configured to create or process a patterned die (e.g., as part of a substrate) for use in die bonding which may or may not include dicing, and any combination selected therefrom) 400, a metrology apparatus 410, a patterned die modification tool 420, and a software application 430. Some, or all, of the die processing system 400, the metrology apparatus 410, and the patterned die modification tool 420 may be in communication with the software application 430 so that results, designs, data, etc. of the die processing system 400, the metrology apparatus 410, and/or the patterned die modification tool 420 may be stored and analyzed by the software application 430 at the same time or different times.

The die processing system 400 may be configured as any appropriate die processing system, such as a lithographic apparatus, a die bonding system, etc. The die processing system 400 may be setup for executing die patterning and/or processing and optionally, may be configured to correct for deviations occurring within the die processing system 400 or in one or more other processes or apparatuses in the die processing. In an embodiment, the die processing system 400 may be able to apply a correction of an error (e.g., relative location error, absolute location error, in one or more direction) by adjusting one or more modification apparatuses of the die processing system 400. That is, in an embodiment, correction may be made by any manufacturing processing tool in the die processing system that can purposefully modify an error. In some embodiments, the die processing system 400 may be corrected for systemic deviations, but may be uncorrected for random (e.g., stochastic variations). In some embodiments, correction for deviations may be instead or additionally performed by the patterned die modification tool.

Where, for example, the die processing system 400 comprises an optical lithographic apparatus, correction of an error can be made by adjusting one or more modification apparatuses of the lithographic apparatus, e.g., by employing an adjustment mechanism to correct for or apply an optical aberration, by employing an adjuster to correct or modify an illumination intensity distribution, by employing a positioner of a reticle or mask support structure and/or a positioner of a substrate table to correct or modify the position of the reticle or mask support structure and/or the substrate table respectively, etc. Where, for example, the die processing system 400 comprises a track tool, correction of an error can be made by adjusting one or more modification apparatuses of the track tool, e.g., modifying a bake temperature of a bake tool of the track, modifying a development parameter of a development tool of the track, etc. Similarly, where, for example, the die processing system 400 comprises an etch tool, correction of an error can be made by adjusting one or more modification apparatuses of the etch tool, e.g., modifying an etch parameter, such as etchant type, etchant rate, etc. Similarly, where, for example, the die processing system 400 comprises a planarization tool, correction of an error can be made by adjusting one or more modification apparatuses of the planarization tool, e.g., modifying a planarization parameter. Similarly, where, for example, the die processing system 400 comprises a deposition tool, correction of an error can be made by adjusting one or more modification apparatuses of the deposition tool, e.g., modifying a deposition parameter. Similarly, where, for example, the die processing system 400 comprises a die bonding tool, correction of an error can be made by adjusting one or more modification apparatuses of the die bonding tool, e.g., modifying a relative position between a donor die and a target die. In an embodiment, one or more modification apparatuses of the die processing system 400 may be able to apply up to third order polynomial correction of errors (e.g., imaging error, focus error, dose error, etc.).

The metrology apparatus 410 may configured to obtain measurements related to substrates printed with patterns by, for example, the die processing system (e.g., donor die, target die, donor substrates, target substrates, features of the donor die, features of the target die, etc.). In an embodiment, the metrology apparatus 410 may be configured to measure or determine one or more locations (e.g., relative or absolute position, rotation, orientation, etc.) of the patterns. In an embodiment, the metrology apparatus 410 is an optical imager, such as a camera, video camera, etc. In an embodiment, the metrology apparatus is a charge particle imager, such as a scanning electron microscope (SEM). In an embodiment, the metrology apparatus 410 is an apparatus configured to measure stress, such as an interferometer, optical beam imager, electron beam imager, etc., in the die or substrate. In an embodiment, the metrology apparatus 410 is an alignment apparatus used to measure relative position between two objects, such as between one or more die and/or substrate and/or support structure. In an embodiment, the metrology apparatus 410 is a level sensor to measure a position of a surface, e.g., a height and/or rotational position of a surface (e.g., of a die or substrate).

In an embodiment, the metrology apparatus 410 measures and/or determines one or more locations associated with a distortion in the die and/or substrate. After the metrology apparatus 410 finishes the measurement or determination, the software application 430 creates modification information based on the measurement data (e.g., a pattern of stress features). In an embodiment, the software application 430 evaluates the one or more values of the one or more locations to determine if they are within a tolerance range. If not, the software application 430 determines modification information to correct an error reflected by the out of tolerance one or more values of the one or more locations.

In an embodiment, the software application 430 uses one or more mathematical models (e.g., one or more geometrical model, stress model, strain model, etc.) to determine if the error may be correctable by one or more modifications of the patterned die. In an embodiment, the model may specify one or more patterns of stress features which may adjust the measured locations of the die and/or substrate to conform (at least more closely) with the planned locations of the die and/or substrate. In an embodiment, the model may specify a pattern of stress relief features, a pattern of stress induction features, and/or a combination of both stress relief and induction features. In an embodiment, the model may specify multiple patters of stress relief features at different depths in the die and/or substrate. In an embodiment, the model may specify a size of the stress features. In an embodiment, the model may specify a recipe to generate the stress features of the pattern, such as a radiation intensity, radiation application time, etc. of a tool to create the stress features, an embodiment of which is discussed hereafter.

In an embodiment, the software application 430 uses one or more mathematical models to determine error correctable by the patterned die modification tool 420 and to provide information for one or more parameters (e.g., modification information) of the patterned die modification tool 420, which one or more parameters enable configuration of the patterned die modification tool 420 to correct (e.g., eliminate or reduce to within a tolerance range) the error. In an embodiment, one or more of the mathematical models define a set of basis functions that fit the data once parameterized. In an embodiment, the one or more mathematical models comprise a model configured to simulate correctable error for the patterned die modification tool 420. In an embodiment, the model specifies a range of modifications that the patterned die modification tool 420 can make and determines correctable error within the range. That is, the range may specify an upper limit, a lower limit, and/or both on the amount of modifications that the patterned modification tool 420.

In an embodiment, the software application 430 may use one or more mathematical models to determine if the error may be correctable by one or more modifications of the die processing system 400 and to provide information for one or more modifications of the die processing system 400 to correct (e.g., eliminate or reduce to within a tolerance range) the error. In an embodiment, one or more of the mathematical models define a set of basis functions that fit the data once parameterized. In an embodiment, the one or more mathematical models comprise a model configured to simulate correctable error for the die processing system 400. In an embodiment, the model specifies a range of modifications that one or more of the modification apparatuses of the die processing system 400 can make and determines correctable error within the range. That is, the range may specify an upper limit, a lower limit, and/or both on the amount of modifications that a particular modification apparatus of the die processing system 400 can make.

In an embodiment, co-optimization of the determination of the error correctable by respectively one or more modification apparatuses of the die processing system 400 and correctable by the patterned die modification tool 420 is provided. In an embodiment, co-optimization of the determination of the error correctable by a plurality of modification apparatuses of the die processing system 400 is provided. In an embodiment, the one or more mathematical models to determine error correctable by one or more modification apparatuses of the die processing system 400 and/or the one or more mathematical models to determine error correctable by the patterned die modification tool 420 are used and/or combined to enable the co-optimization. In an embodiment, the co-optimization leads to transformation of a non-correctable error by a modification apparatus of the die processing system 400 to a correctable error by one or more other modification apparatuses of the die processing system 400 and/or by a modification of the patterned die by a patterned die modification tool 420. As an example of such transformation, an error having an uncorrectable spatial resolution for a modification apparatus of the die processing system 400 can be enabled for correction by adding further error such that the total error has a spatial resolution correctable by the modification apparatus of the die processing system 400. In an embodiment, the added error is divided among a plurality of other modification apparatuses of the die processing system 400 or divided among one or more other modification apparatuses of the die processing system 400 and the patterned die modification tool 420.

In an embodiment, the co-optimization is performed separately or on a combined basis for different types of error, such as performed separately or on a combined basis for overlay error, focus error, dose error, etc. In an embodiment, certain modification apparatuses of the die processing system 400 may be better able to correct certain types of error and so the error correction is appropriately weighted or apportioned among the suitable different modification apparatuses of the die processing system 300.

In an embodiment, a user may specify the one or more mathematical models from a collection of a plurality of mathematical models, whether that mathematical model is determined to be a fit or not. For example, an interface (such as a graphical user interface) may allow the user to specify the mathematical data model for consideration. In an embodiment, a plurality of measurement mathematical data models is determined or specified. In an embodiment, the one or more mathematical models may be tuned for optimal noise suppression (e.g., eliminating redundant orders or reducing the use of higher orders).

For example, in an embodiment, the correctable error $\Delta x$ in an X direction at the coordinate $(x,y)$, may be modeled by Equation 1 , below:

$$\Delta x = k_1 + k_3 x + k_5 y + k_7 x^2 + k_9 xy + k_{11} y^2 + k_{13} x^3 + k_{15} x^2 y + k_{17} xy^2 \qquad (1)$$
$$+ k_{15} x^3 \dots$$

where $k_1$ is a parameter (that may be constant), and $k_3$, $k_5$, $k_7$, $k_9$, $k_{11}$, $k_{13}$, $k_{15}$, $k_{17}$, and $k_{19}$ are parameters (that may be constant) for the terms $x$, $y$, $xy$, $x^2$, $y^2$, $x^3$, $x^2y$, $xy^2$, and $y^3$, respectively. One or more of $k_1$, $k_3$, $k_5$, $k_7$, $k_9$, $k_{11}$, $k_{13}$, $k_{15}$, $k_{17}$, and $k_{19}$ may be zero.

Analogously, in an embodiment, the correctable error $\Delta$y in an Y direction at the coordinate (x,y), may be modeled by Equation 2, below:

$$\Delta \text{y} = k_2 + k_4 y + k_6 x + k_8 y^2 + k_{10} xy + k_{12} x^2 + k_{14} y^3 + k_{16} y^2 x + k_{18} yx^2 \qquad (2)$$
$$+ k_{20} x^3 \dots$$

where $k_2$ is a parameter (that may be constant), and $k_4$, $k_6$, $k_8$, $k_{10}$, $k_{12}$, $k_{14}$, $k_{16}$, $k_{18}$ and $k_{20}$ are parameters (that may be constant) for the terms $y$, $x$, $xy$, $y^2$, $x^2$, $y$, $y^2x$, $yx^2$, and $x^3$, respectively. One or more of $k_2$, $k_4$, $k_6$, $k_8$, $k_{10}$, $k_{12}$, $k_{14}$, $k_{16}$, $k_{18}$ and $k_{20}$ may be zero.

Likewise, a correctable error $\Delta$z in a Z direction (e.g., out of the plane of fabrication) may be modeled, including locally. The correctable error $\Delta$z in the Z direction may not be additive, as described for the $\Delta$x and $\Delta$y correctable errors, but may instead decay (for example, radially) around a correction due to surface tension of the substrate, rigidity of the substrate, or other material properties.

In an embodiment, at least part of the correctable error is corrected by the patterned die modification tool 420. So, in an embodiment, a portion of the error that fits the mathematical model is correctable by the patterned die modification tool 420 by adjusting one or more modification apparatuses of the patterned die modification tool 420. In an embodiment, at least part of the correctable error may be corrected by the die processing system 400 through adjusting one or more of the modification apparatuses of the die processing system 400. So, in an embodiment, a portion of the error that fits the mathematical model is correctable by the die processing system 400 by adjusting one or more modification apparatuses of the die processing system 400.

A minimum remaining systematic variation for certain processed die may be specific to particular sub-processes or devices used in the processing of the substrates and/or to stochastic variations. The minimum remaining systematic variation is sometimes referred to as a fingerprint. The fingerprint may not be correctable by one or more modification apparatuses of the die processing system 400. In an embodiment, the fingerprint is corrected by modifying the patterned die using the patterned die modification tool 420. In an embodiment, remaining systematic variation between the measurement data and the corresponding data calculated using the model (1) and model (2) is minimized by optimizing parameters (e.g., one or more of $k_4$ - $k_{20}$ or other parameters corresponding to correctable error $\Delta$z).

In an embodiment, the software application 430 creates first modification information for modifying the patterned die by the patterned die modification tool 420 and transmits the first modification information to the patterned die modification tool 420. In an embodiment, after modifying the patterned die, the software application 430 instructs the patterned die modification tool 420 to transmit the modified patterned die to the die processing system 400 for use, in for example, further production such as die bonding or for further patterning associated with the modified patterned die. In an embodiment, further error correction and/or verification of the modified patterned die is performed as discussed below. In an embodiment, the first modification information may effectively transforms non-correctable error by the die processing system 400 to a correctable error for the die processing system 400 upon modification by the patterned die based on the first modification information.

In an embodiment, the software application 430 may further create second modification information for one or more modification apparatuses of the die processing system 400 and transmit the second modification information to the die processing system 400. In an embodiment, the second modification information enables correction of correctable error of the die processing by the one or more modification apparatuses of the die processing system 400 upon adjustment, based upon the second modification information, of the die processing by the one or more modification apparatuses of the die processing system 400 and use of the modified patterned die in the die processing system 400. That is, in an embodiment, one or more modification apparatuses of the die processing system 400 are configured to correct the correctable error produced by the patterned die modified based on the first modification information. In an embodiment, additionally or alternatively, the second modification information corrects residual error remaining after modification of the patterned die based on the first modification information.

In an embodiment, the first and second modification information may work in opposite directions. For example, the first modification information may bend the substrate/die in one direction while the second modification may bend the substrate/die (or create some other correction with similar or equivalent effect) in the opposite direction such that combining the two would allow for correction of any deformation that the substrate/die might have.

In an embodiment, the software application 430 uses, additionally or alternatively, one or more machine learning techniques, such as a trained machine learning model, to arrive at modification information. In an embodiment, the software application 430 uses, additionally or alternatively, one or more look up tables to arrive at modification information. In an embodiment, any combination of processing techniques can be used, such as, without limitation, a combination of machine learning with one or more look up tables (e.g., the machine learning identifies which correction to choose from a look up table).

In an embodiment, a substrate processed in the die processing system 400 with the modified patterned die and/or adjusted die processing method is forwarded to the metrology apparatus 410 for measurement. The metrology apparatus 410 performs measurement in a similar way as discussed above to evaluate whether error is within a tolerance range (e.g., by evaluating one or more locations of the die and/or substrate or features of the die and/or substrate measured or located by the metrology apparatus 410). If the error is not within tolerance, in an embodiment, additional modification of the patterned die by the patterned die modification tool 420 and/or adjustment of one or more parameters of the one or more modification apparatuses of the die processing system 400 is performed as similarly discussed herein.

In an embodiment, after the patterned die modification tool 420 modifies the patterned die, the patterned die is transferred back to the metrology apparatus 410 to repeat the process described above until the error is within tolerance.

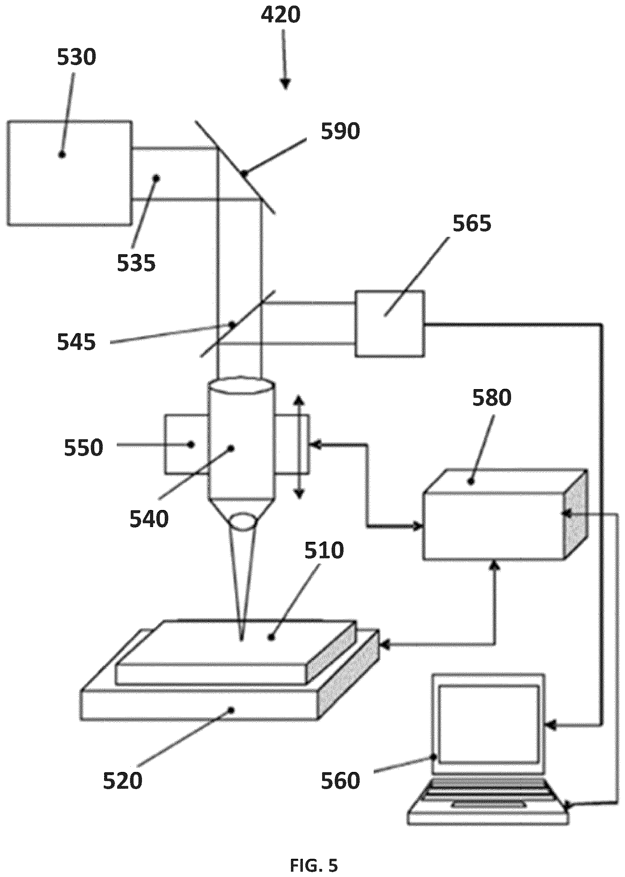

Figure 5 is a schematic diagram illustrating portions of an example apparatus for stress release and/or induction in one or more dies. Figure 5 schematically depicts a block diagram of an example patterned die modification tool 420 configured to modify a patterned die (e.g., a donor die, a target die, a substrate containing donor die, a substrate containing target die, and any portions thereof). The patterned die modification tool 420 comprises a table 520 which may be movable in up to six dimensions. The patterned die 510 may be held by the table 520 by using, for example, clamping (e.g., vacuum clamping, electrostatic clamping, etc.).

The patterned die modification tool 420 includes a radiation output (e.g., a pulse laser source) 530 configured to produce a beam of radiation 535 (e.g., pulses of radiation). The output 530 may provide radiation pulses of variable duration, variable intensity, etc. Typically, the output is configured to provide radiation with a photon energy which is smaller than the band gap of the substrate (including any layer at which the radiation is directed) of the patterned die 510 and able to provide radiation pulses having durations in, e.g., the femtosecond range.

The pulses from the output 530 (e.g., a laser system) can, for example, write an arrangement of local deformation elements (e.g., providing local density variation) by altering a materials property (e.g., density) of that substrate (including any layer thereof such as any layer described, including, without limitation, any stress relaxation and/or compensation layer described herein), such as by heating (e.g., thermal expansion), vaporization (e.g., conversion of a solid to a less dense liquid or gas), phase-separation, crystallization, de-crystallization, etc. The local deformation element may cause a volumetric change in the patterned die 510. The local deformation element may cause a change in the stress, strain, etc. of the patterned die 510. The local deformation element may, for example, shift one or more pattern elements on the surface of the patterned die to or from a predetermined position. Thus, the induced deformation element of the patterned die can modify or correct, for example, pattern placement on the surface of the patterned die. An arrangement of local deformation elements (e.g., stress elements) may be defined and written which modifies or corrects placement of features on the surface of the patterned die. In an embodiment, the local deformation elements (e.g., stress elements) may be introduced in a central or inner portion of the patterned die. Applying such local deformation elements (e.g., stress elements) in a central or inner portion of the substrate may avoid a bending of a portion of the patterned die, while, e.g., modifying or correcting feature locations. A laser, such as a femtosecond or ultra-short laser, can access a region below the surface without destroying the surface. At the focal point (which can be set below the surface), the temperature can rise to a very high temperature (> 1000C) and/or induce high compressive stress. The high temperature and/or high compressive stress can induce recrystallizations, dislocations, and/or microvoids in the inside of the applicable layer/structure. In an embodiment, the radiation output can produce multiple separate beams to allow creation of multiple local deformation elements in parallel.

The steering mirror 490 directs the beam 535 into focusing objective 540. The objective 540 focuses the beam 535 onto the patterned die 510. The patterned die modification tool 420 also includes a controller 580 and a computer system 560 which manage the translations of the positioning stage of the table 520 in plane generally perpendicular to the beam (X and/or Y directions) and/or translations about an axis parallel to the plane (about the X and/or Y direction). The controller 580 and the computer system 560 may control the translation of the table 520 in a direction perpendicular to the plane (Z direction) and/or rotation about that direction (about the Z direction). Additionally or alternatively, the controller 580 and the computer system 560 may control the translation and/or rotations of the objective 540 via the positioning stage 550 to which the objective 540 is fixed. In an embodiment, the objective is fixed and all motions are performed using the table 520. In an embodiment, the patterned die modification tool 420 may comprise one or more sensors (not shown for convenience only) to detect positions of components, such as the table 520 and/or objective 540, determine focusing/leveling, etc. In an embodiment, the patterned die modification tool 420 may be integrated into a die bonding tool, such as into the apparatus of Figures 3A-3J.

The patterned die modification tool 420 may also provide a viewing system including a CCD (charge-coupled device) camera 565, which receives radiation from an illumination output (e.g., radiation source) arranged in the table 520 via optical element 545. The viewing system may facilitate navigation of the patterned die 510 to the target position. Further, the viewing system may also be used to observe the formation of a modified area on the patterned die 510 by the beam 435 of the source 530. The camera 565 may be any appropriate camera, such as a camera of a measurement system as described in reference to the apparatus of Figures 3A-3J.

The computer system 560 may be a microprocessor, a general-purpose processor, a special purpose processor, a CPU (central processing unit), a GPU (graphic processing unit), or the like. It may be arranged in the controller 580, or may be a separate unit such as a PC (personal computer), a workstation, a mainframe, etc. The computer 560 may further comprise I/O (input/output) units like a keyboard, a touchpad, a mouse, a video/graphic display, a printer, etc. In addition, the computer system 560 may also comprise a volatile and/or a non-volatile memory. The computer system 560 may be realized in hardware, software, firmware, or any combination thereof. Moreover, the computer 560 may control the output 530. The computer system 560 may contain one or more algorithms, realized in hardware, software or both, which allow creation of control signals for the patterned die modification tool 520 from received data, e.g., experimental data. The control signals may control the writing of an arrangement of local deformation elements and/or local transmission variations in the substrate of the patterned die 510 in order to, for example, correct the pattern placement or optical transmission in accordance with the received data. In particular, the computer system 560 may control the source 530 and/or the table 520 positioning and/or the objective 540 positioning or optical parameters and/or the CCD camera 565.

In an embodiment, the effects of local deformation elements may be described by a physical mathematical model that represents the deformation or variation caused by the beam. The direction of the deformation or variation may be controlled by applying different local deformation elements in the substrate having different deformation properties. The deformation properties of a given local deformation element (e.g., stress element), such as magnitude and direction represent a specific mode. For example, an "X mode" represents a deformation or variation along the X axis and is described by the "X mode" properties. When the control signals are calculated, the one or more algorithms may compute where and in what density each type of local deformation element (e.g., stress element) should be written. For example, a registration error in the X direction can be corrected by an X mode type of local deformation element. The model may use several modes in order to optimize a best possible solution for a specific problem. Typically, X and Y modes which are orthogonal to each other will be used but other modes such as 45° and 135° may also be used if required. In some embodiments, a Z mode (or other mode not parallel to the plane of fabrication) may also be used.

So, in an example patterned die modification process, the positions of features on a surface of the patterned die (which features are created by an example patterned die production process) may be determined with a metrology system (not shown) in order to determine whether, e.g., the patterning process was successful-that is, that the patterned features are at the desired positions. If the determined errors are not within a predetermined level, an arrangement of local deformation elements (e.g., stress elements) are written into the patterned die using, for example, the patterned die modification tool 420 of Figure 4. The local deformation elements can shift the position of one or more feature of the patterned die to a predetermined position. Then, it may be measured whether the modification of the patterned die was successful. For example, if the measured positioning error is now below the predetermined threshold, the patterned die may be further processed, such as by die bonding.

In an embodiment, the patterned die modification tool 420 comprises the tool that writes the pattern of the patterned die. For example, an e-beam writer may be used to create the pattern of the patterned die. The modification information described herein may be provided to such a tool to modify creation of the patterned die. In such a case, the modification information may be determined based on measurement and/or simulation results using other copies of the patterned die or using similar patterned die. Such data may be supplemented by measured data of the patterned die that is being created (e.g., measurements obtained at the time of creation of the patterned die).

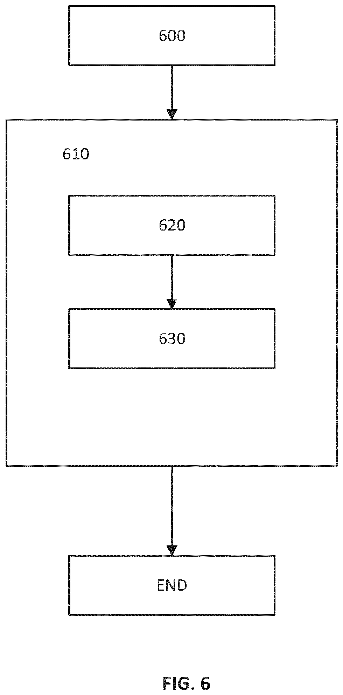

Figure 6 is a flowchart which illustrates an exemplary method of die stress modification. The method conducted in the flow diagram of Figure 6 may be performed by the software application 430. The operations of method of Figure 6 presented below are intended to be illustrative. In some embodiments, method of Figure 6 may be accomplished with one or more additional operations not described, and/or without one or more of the operations discussed. Additionally, the order in which the operations of the method of Figure 6 are illustrated and described below is not intended to be limiting. In some embodiments, one or more portions of method of Figure 6 may be implemented (e.g., by simulation, modeling, etc.) in one or more processing devices (e.g., one or more processors). The one or more processing devices may include one or more devices executing some or all of the operations of method of Figure 6 in response to instructions stored electronically on an electronic storage medium. The one or more processing devices may include one or more devices configured through hardware, firmware, and/or software to be specifically designed for execution of one or more of the operations of the method of Figure 6, for example.

At 600, information regarding an error in patterning is obtained in relation to a patterned die (which may be a patterned substrate or part of a patterned substrate or even a region of a patterned die). In an embodiment, the patterning error is a feature placement error. In an embodiment, the patterning error is a stress-induced pattern distortion. In an embodiment, a portion of the error is not correctable by a modification apparatus of a die processing system (e.g., the die processing system 400). In an embodiment, the patterning error information is derived based on measurement of the locations of one or more features of the patterned die.

At 610, modification information for modifying a patterned die based on the error information is created. In an embodiment, the modification information is used by a patterned die modification tool 420 (such as a system the same as or similar to the system described in respect of Figure 4). In an embodiment, at 610, modification information for the modification apparatus of the die processing system is created based on the error information and modification information for modifying the patterned die.

In an embodiment, at 610, the modification information is converted 620 to a recipe that spatially distributes across the patterned die one or more induced local deformation elements (e.g., stress elements). In an embodiment, the spatially distributed one or more induced local deformation may transform the portion of the patterning error to a correctable error for the die processing system (e.g., the die processing system 400).

At 630, the one or more induced local deformation elements (e.g., stress features) are created within the substrate of the patterned die. In an embodiment, creating the induced local deformation element comprises creating an induced local density variation by using laser pulses to change a materials property of the substrate as described above with respect to Figure 5.

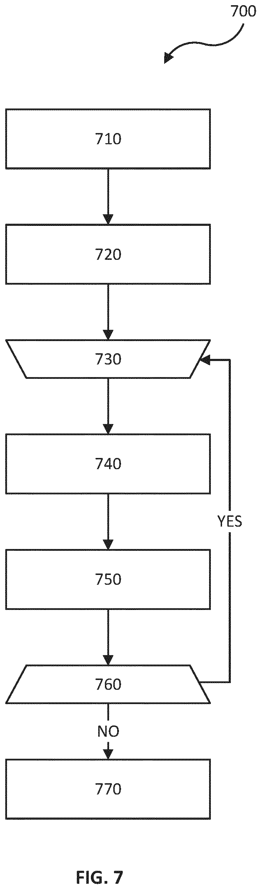

Figure 7 is a flowchart which illustrates an exemplary method of die placement. Each of these operations is described in detail below. The operations of method 700 presented below are intended to be illustrative. In some embodiments, method 700 may be accomplished with one or more additional operations not described, and/or without one or more of the operations discussed. Additionally, the order in which the operations of method 700 are illustrated in Figure 7 and described below is not intended to be limiting. In some embodiments, one or more portions of method 700 may be implemented (e.g., by simulation, modeling, etc.) in one or more processing devices (e.g., one or more processors). The one or more processing devices may include one or more devices executing some or all of the operations of method 700 in response to instructions stored electronically on an electronic storage medium. The one or more processing devices may include one or more devices configured through hardware, firmware, and/or software to be specifically designed for execution of one or more of the operations of method 700, for example.

At an operation 710, a plurality of donor die locations are obtained. The donor die locations may be obtained via measurement of one or more positions of the donor dies along one or more dimensions. The donor dies may lie on or be part of a donor substrate (e.g., a carrier structure, a semiconductor substrate, etc.), and the locations of the plurality of donor dies may be obtained with respect to that donor substrate. The locations of the plurality of donor die may be measured with respect to a measurement mark. The locations of the plurality of donor dies may be measured in-plane (e.g., in the X-Y plane). The locations of the plurality of donor dies may also be measured via a first method in-plane and measured out of plane (e.g., in the Z direction) via a second method. For example, the locations of the plurality of donor dies may be measured based on one or more images in-plane. The locations of the plurality of donor dies may be obtained from a two-dimensional image, which may show locations of an edges or corner of a donor die with respect to positions on a support structure or on a die actuator. The locations of the plurality of donor dies may be obtained based on one or more features (for example, one or more electrically active areas) on an exposed surface of the donor die. These one or more features of the donor die may be used as an alignment mark or reference mark. In some embodiments, alignment marks may be included as exposed features of the donor die. The alignment marks may be specifically added for die bonding or may be alignment marks corresponding to previous fabrication steps. The plurality of donor die locations may be measured or obtained from storage.

At an operation 720, a plurality of target die locations are obtained. The target dies may lie on or be part of a target substrate (e.g., a carrier structure, a semiconductor substrate, etc.), and the locations of the plurality of target dies may be obtained with respect to that target substrate. The locations of the plurality of target die may be obtained in any appropriate method, including any of those described in reference to the operation 710.

At an operation 730, a donor die is selected from the plurality of donor dies. The donor die may be selected based on position (e.g., along a row, along a column), displacement (e.g., donor die closest to an ideal position), thickness (e.g., thicker dies may be placed before thinner dies, including if donor dies include two or more types of dies), etc. The donor die may have a corresponding target die, such as a target die in a corresponding location on a target substrate (e.g., target die carrier structure). In some embodiments, a target die may be selected, by any appropriate method, and a donor die selected based on its correspondence to the selected target die. The donor die and the target die may be brought together such that donor die and its corresponding target die are separated by a distance which may be traversed by the die placement method. The donor die and target die may be grossly aligned (e.g., coarse aligned), such as to within a threshold of coarse alignment. The donor die and target die may be held in proximity by one or more substrates, chucks, actuators, adhesives, etc.

At an operation 740, the relative position between the selected donor die and the corresponding target die is adjusted to have alignment between the donor die and the corresponding target die. Adjusted includes cases in which locations are minimally or substantially not adjusted (e.g., after measurement or bringing into proximity), such as if a measured location corresponds to the target location within a threshold. In an embodiment, the position of the donor die may be adjusted by action of a die actuator, a substrate holder, a chuck, etc. The position of the donor die may be adjusted by action of a substrate handling apparatus. The position of the donor die may be adjusted in one or more directions, such as in the X-Y plane. Alternatively or additionally to adjustment of the location of the donor die, the position of the target die may be adjusted, by any appropriate method, such as any of those previously described. Adjustment of the relative position between the donor and target die may include iterative measurement of donor and/or target die location, including as adjustment occurs.

Adjustment of the location of the donor die may occur based on an alignment location for the donor die. The alignment location may be a target (e.g., target location) for placement of the donor die. A target (e.g., target location) may be obtained, such as at operation 720, from measurement of the target die position. The target may correspond to a location of the target die. The target may correspond to a plurality of locations on the target die. The target may be a position (e.g., a position in three dimensions such as along X, Y, and Z axes, positions in six directions such as along X, Y, and Z axes and with respect to angles of rotation about those axes, etc.). The target may be a set of positions, for example two or more positions of or on a target die to which areas of the donor die are to be bonded. Additionally or alternatively, adjustment of the location of the target die may occur based on an alignment location for the target die. The alignment location may be a target (e.g., target location) for placement of the donor die. A target (e.g., target location) may be obtained, such as at operation 710, from measurement of the donor die position. The target may correspond to a location of the donor die. The target may correspond to a plurality of locations on the donor die.

At an operation 750, the selected donor die is placed on the corresponding target die. The donor die may be placed on the target die by any appropriate method, such as by movement of a die actuator, by radiation-mediated bonding, by stamping, by electrostatic attraction, etc. The donor die may experience alignment, including self-alignment, as the donor die is brought into contact with the target die. The donor die may be adhered to the target die as it contacts the target die, such as by van der Waals forces. In some embodiments, an additional donor die may be placed on the same or different target die.

At an operation 760, it is determined if additional donor die remain for placement. If additional donor die (e.g., on the donor substrate or substrate) remain for placement, the flow continues to the operation 730 where another donor die is selected. If no additional donor die remain for placement, flow continues to operation 770, where the bonding of the plurality of dies is completed.

In an embodiment, a particular donor die and target die are bonded at the time the donor die is placed on the target die, e.g., through intermolecular bonding. In an embodiment, the donor die is bonded, such as through annealing or other bonding process, to the target die after placement of the donor die on the target die. In an embodiment, a bonding of a donor and target die is completed before a next donor die is placed on a target die. In an embodiment, bonding of a donor and target die is completed after a plurality of donor dies are placed on respective target dies, e.g., after all the donor dies on a donor substrate are placed. In an embodiment, a donor die placed on a target die is annealed to form or enhance electrical connection. In an embodiment, the annealing of a particular donor die and target die can be done prior to a next donor die is placed on a target die. In an embodiment, annealing of a donor and target die is completed after a plurality of donor dies are placed on respective target dies, e.g., after all the donor dies on a donor substrate are placed. The donor die may be held against the target die for a bonding or annealing time period. A donor die and target die pair may be released from a substrate or other holding apparatus before annealing or after annealing has occurred.

As described above, method 700 (and/or the other methods and systems described herein) is configured for die placement.

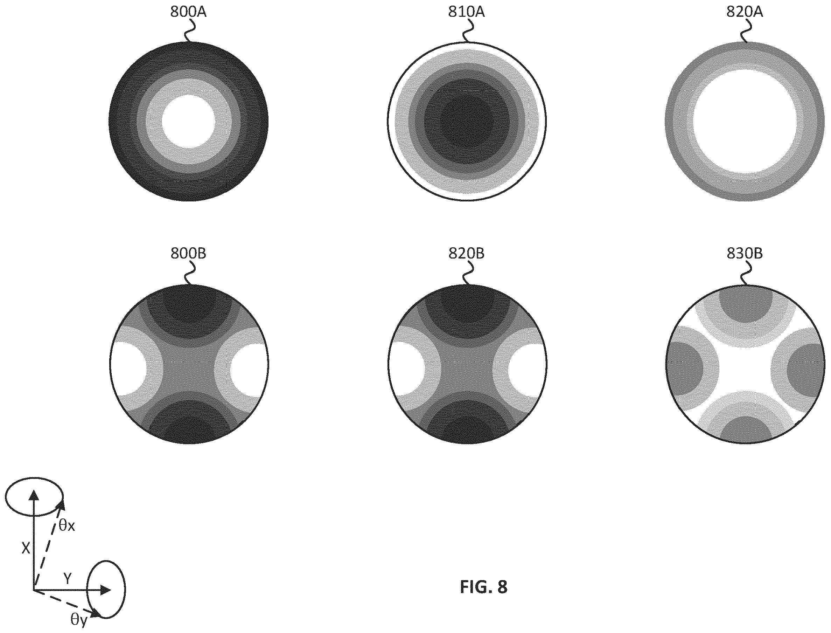

Figure 8 is a schematic representation of an exemplary distortions, patterns of stress features, and corrections to the distortion by application of the patterns of stress features. The exemplary distortions are depicted for example as dies/substrates 800A and 800B. As will be appreciated, actual distortions may have a much more complex spatial signature and so the depicted distortions are just relatively simple examples to illustrate embodiments of the disclosure. The example die/substrates may be donor and/or target substrates, including diced, reconstructed, or undiced substrates, or donor and/or target die, which may be supported by one or more substrates. The distortions may be stress induced distortions. The distortions may be induced by a fabrication process. The distortions may be induced by a die bonding process, including a process in which the die/substrates 800A and 800B are bonded to one or more additional substrate or die. The distortions may be measured by measuring stress in the example dies/substrates, such as through interferometry, optical beam imaging, electron beam imaging, etc. The distortions may be measured by measuring locations of features on the dies/substrate and comparing those measured locations to planned locations of the features. The distortions may be a difference between measured (e.g., actual) locations of features and corresponding target locations, such as on one or more corresponding target and/or donor die/substrate to which the example die/substrate are to be bonded. In such a case, the distortions may not have a stress-induced component or may have a minimal stress-induced component. The distortions may have both a direction and a magnitude (e.g., may be represented by a vector). In some embodiments, the distortions may have only a magnitude, such as a measure of induced stress.

Figure 8 depicts two exemplary distortions, a radial distortion in die/substrate 800A and a saddle distortion in die/substrate 800B. In the radial distortion of die/substrate 800A, the absolute magnitude of the distortion is displayed in grayscale, where white represents minimal distortion and black represents the largest distortion present, which may still be a relatively small distortion on the order of nanometers. The radial distortion of the die/substrate 800A is smallest at the central portion of the die/substrate and largest at the edge(s), consistent with radial stress, such as may be induced by chucking, or radial feature pattern error, such as induced by substrate bowing during photolithography. In the saddle distortion of die/substrate 800B, the magnitude and direction of the distortion is displayed in grayscale, where gray represents minimal distortion, black represents the largest positive distortion and white represents the largest negative distortion (where positive and negative distortions may be relative and determined based on the selection of axes). The saddle distortion of the die/substrate 800B is smallest at the central portion of the die/substrate, and largest in different directions (such as compression and expansion) at different portions of the edge(s) of the die/substrate 800B. The saddle distortion of die/substrate 800B may be associated with one or more different types of substrate processing error, substrate stress (such as induced during lithography or another patterning process), chucking stress, etc.

The exemplary patterns of stress features for the die/substrates 800A and 800B are depicted as patterns 810A and 810B, respectively. The patterns of stress features may include multiple stress features which alter a volume and/or density of the substrate. The patterns of stress features as depicted show a magnitude of stress features, but not individual stress features themselves. The magnitude of the stress features may correspond to a density of stress features (e.g., how closely the stress features are placed with respect to one another in the plane of fabrication-the X-Y plane-and/or in the Z-direction perpendicular to the plane of fabrication), a size of stress features (e.g., a size of each of the individual stress features), etc. The stress features may have a magnitude of positive or negative value. For example, some stress features may cause an increase in volume/decrease in density, while other stress features may cause a decrease in volume/increase in density of one or more layers of the substrates (e.g., of the patterned die). In some embodiments, a stress feature may cause a decrease in volume if placed in a pre-stressed layer (for example, a layer with a gradient in the lattice constant) which may relax, including by reduction in one or more dimensions of the crystal unit cell, when a stress feature is generated. In some embodiments, the stress features may have only positive magnitudes, such as if the stress features cause an increase in volume and/or decrease in density in substantially all instances.

In the radial distortion of pattern 810A, the magnitude of the pattern of stress features may be the inverse of the magnitude of distortion of die/substrate 800A. For example, the pattern of stress features may be intense (depicted as black in the grayscale intensity scheme) in the central portion of the die/substrate, such that the total positional change induced in the die/substrate is greatest at the edges. The pattern of stress features may be less intense along the edge(s), where the features at the edge(s) of the die/substrate 800A may still experience the most positional change, due to the total number of stress features between the features of the edge and the features of the central portion. In the saddle distortion of pattern 810B, the magnitude of the pattern of stress features may be a mirror of the magnitude and direction of the distortion of the die/substrate 800B. For example, the pattern of stress features may feature positive and negative volumetric stress features (e.g., as depicted as black and white regions, respectively, in the grayscale intensity pattern), which may expand and compress the surface (or backside or any other appropriate layer) of the die/substrate 800B to compensate for the as-fabricated stress and/or distortion.

The die/substrates 820A and 820B may represent the distortions of the die/substrates 800A and 800B, respectively, after the application of the respective patterns of stress features of patterns 810A and 810B. The corrected dies/substrates may not have fully eliminated distortion or perfectly corrected feature locations, but may be suitable for alignment in a die bonding process. In some embodiments, the correction may be an iterative process, in which the distortions of the die/substrate are measured, patterns of stress features generated and applied to the die/substrate, and the distortions of the die/substrate re-measured, until the distortions fall below a threshold for die bonding or another process.

So, in embodiment, strain elements (e.g., microvoids) can be created inside a die/substrate, e.g., using a laser such as a femto-second laser, to correct die/substrate deformation. In an embodiment, placement accuracy of a feature of a donor die to a target die can less be than or equal to 10 nm, less be than or equal to 5 nm, less be than or equal to 2 nm or less be than or equal to 1 nm. Local die/substrate deformations (e.g., high frequency ones) can be larger than this, e.g. often tens of nm. Therefore, in an embodiment, the die/substrate deformation is corrected to deformation less than or equal to the placement accuracy.

In an embodiment, there is provided a method to pre-correct a to-be-bonded die/substrate locally using one or more strain elements induced in the die/substrate using, e.g., a laser as described above. In an embodiment, the method includes measuring die/substrate do determine die/substrate deformation. Such deformation can be measured using a measuring technique including, e.g., using an alignment technique measuring alignment markers or features. From these measurements, a die/substrate map can be generated which describes the die/substrate deformations. Based on this information, stress features (e.g., microvoids) can be induced below a surface of the die/substrate using, e.g., a laser as described above. These stress features locally deform at least part of the die/substrate so as to shift features on a surface of the die/substrate in a particular direction; for example, expansion below the surface can also cause a patten on the surface of the die/substrate to shift. The size, depth, position, etc. of the stress features are carefully tuned/selected to enable the desired counteracting of undesired deformation and to avoid possible device damage.

In an embodiment, the stress features can be induced in a same tool used to make measurements. For example, the radiation used to perform measurement can be tuned to instead create the stress features. So, in an embodiment, the tool can first measure the die/substrate and then the radiation is switched to create the stress features. In an embodiment, the same optics can be used for measurement and stress feature creation. In an embodiment, one or more optical elements can be changed, altered, reconfigured, etc., between the measurement and stress feature creation to allow for the optics to perform both functions. In an embodiment, the tool is an alignment measurement tool. In an embodiment, the tool is a lithographic apparatus, e.g., the exposure column can be used to create the stress features and a measurement system in the lithographic apparatus can be used to make the measurements. In an embodiment, the tool can be a two stage apparatus wherein the stress features are created on a die/substrate held by a first stage and measurements are made of a die/substrate held by a second stage and then the second stage can shifted to the location where stress features can be created. In an embodiment, the stress features can be induced in a different tool from that used to make measurements.

In an embodiment, local (high-spatial-frequency) deformations can be repaired before bonding of the die/substrate to another die/substrate. In an embodiment, one or more global (low-spatial-frequency) deformation can be corrected by other methods, e.g., relative positioning, etc.

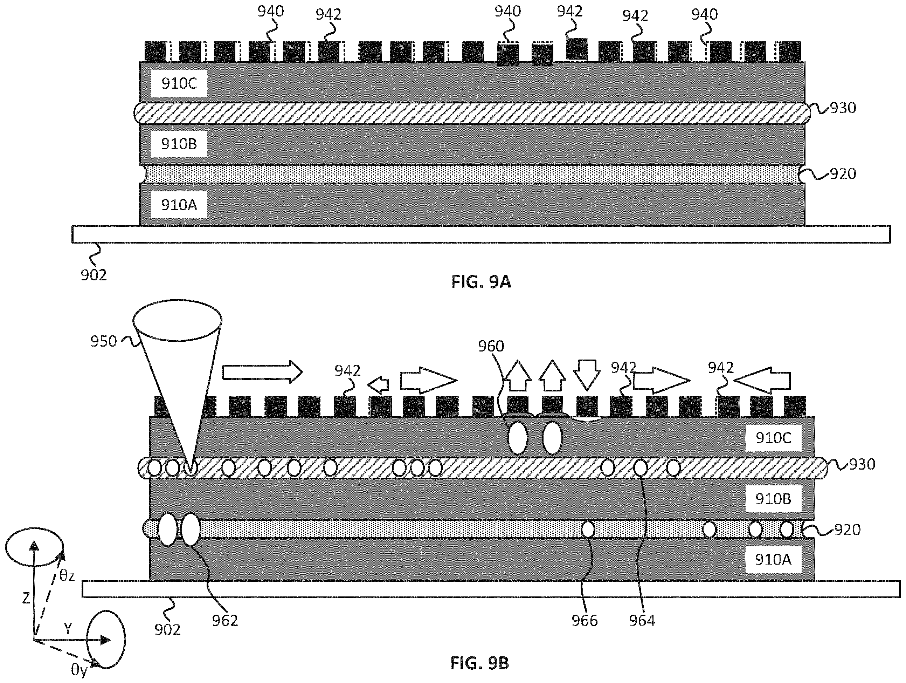

Figures 9A and 9B are schematic diagrams illustrating correction of feature locations by application of a pattern of stress features for an exemplary die, according to one or more embodiments. Figure 9A depicts a cross-sectional view of an exemplary patterned die. The patterned die is supported by a support 902, which may be a substrate table, a substrate, a substrate chuck, or any other appropriate support. In one or more embodiments, the support 902 may be another substrate or die to which the patterned die has been bonded, including a further patterned die. The patterned die may contain multiple layers, including what are depicted as bulk layers 910A-910C. The bulk layers 910A-910C may contain portions of integrated circuit devices fabricated therein (for example, transistors, metal lines, through silicon vias (TSVs), etc.), which are not depicted for ease of description. The bulk layers 910A-910C may be thinned layers, such as thinned by CMP after patterned die fabrication, or un-thinned layers, such as present in an un-patterned die. The patterned die may contain one or more compensation layers, such as compensation layer 920 and compensation layer 930, within the die or on an external surface of the die, such as on the bottom external surface of layer 910A. The one or more compensation layers may comprise one or more pre-stressed layers. The one or more compensation layers may comprise one or more compensation layers that are continuous, such as if placed below portions of the integrated circuit devices fabricated therein (e.g., in portions of the patterned die to be thinned). The one or more compensation layers may comprise one or more compensations that are non-contiguous, e.g., have one or more regions where compensation layer is not present (e.g., regions in the X-Y plane). For example, the one or more compensation layers may be patterned, such that they do not intersect with or alter the portions of the integrated circuit devices fabricated therein. The one or more compensation layers may be of any appropriate material, such as amorphous silicon, silicon dioxide, crystalline, a semiconductor, glass or glassine, etc. The one or more compensation layers may be of any appropriate thickness. In some embodiments, the thickness of the one or more compensation layers may restrict the size of the stress features. In some embodiments, the stress features may expand anisotropically (e.g., differently in different directions) due to confinement in a compensation layer.

The patterned die may have one or more features, e.g., features 942. The features may be one or more selected from: a part of a transistor, a part of memory cell, metal line or via, a connection, a bonding pad, etc. The features 942 are depicted as protruding from top of the patterned die (for ease of depiction), but may be recessed, co-planar, or have any other appropriate relationship with the surface of the patterned die. The features 942 may have an intended (e.g., planned) position, represented by the dotted boxes 940. The locations of the features 942 may vary from the planned positions due to fabrication errors, such as lithography errors, etching induced stress, thermal stress, etc., or due to other stress related distortions, such as chucking distortions. The difference between the (actual) locations and the planned locations of the features 942 may be the distortion itself or a result of another distortion (for example, substrate bending). In either situation, the difference between the locations and the planned locations of the features may be mitigated by application of a pattern of stress features to the patterned die.

Figure 9B depicts a cross-sectional view of the exemplary patterned die of Figure 9A after application of a pattern of stress features. The stress features may be patterned by various means. For example, the stress feature may be patterned by an energy source 950, which may be a radiation source (such as an electromagnetic source, including a laser source with, e.g., a wavelength of 8000 nm or less, 5000 nm or less, 2000 nm or less, 1000 nm or less, 500 nm or less, 300 nm or less, 200 nm or less, or 100 nm or less), etc. The stress features may be patterned by interaction of two or more beams of energy from one or more energy sources, such as a laser beam transmitted into the compensation layer 930 and a laser beam transmitted by the energy source 950. In some embodiments, the energy source may produce pulses of energy which irradiate the patterned die. The energy pulses may be femtosecond or longer pulse durations. The energy pulses may have any appropriate pulse intensity. In some embodiments, the energy pulses may be of a wavelength which lies in a bandgap of the bulk layers. In some embodiments, the wavelength of the energy pulses may be tuned to an absorptive region of the spectrum of the compensation layer. The energy source may produce stress features in any appropriate layer, including in the one or more compensation layers, in the bulk layers, on the surface of the patterned die, on the backside of the patterned die, etc. In Figure 9B, the energy source is depicted as applying energy to the patterned die through the frontside, but energy may be applied instead or additionally through the backside, including through the support 902. In an embodiment, the stress features may be created by patterned application of the one or more stress compensation layers. For example, a stress compensation layer may be formed to have a stress in a pattern therein or may be formed to have a pattern capable of relieving stress. In an embodiment, the stress features may be created mechanically, e.g., by cutting, abrading, etc. one or more compensation layers.

The patterned die of Figure 9B contains multiple different types of stress features. Of course, a die need not have all these different types of stress features; they are shown together here for convenience. Stress features 960 are depicted as being formed in the bulk layer 910C, close to the surface. Stress features 960, which are centered under some of the features 942, are depicted as causing a corresponding change in the height of the features 942 (e.g., a correction in the Z) direction; of course, they may be used to cause a change in a different direction (e.g., a correction in X and/or Y direction). Stress features 962 are depicted as being formed in the compensation layer 920, which may be a pre-stressed layer, and extending into the bulk layers 910A and 910B. In some embodiments, a stress feature may occupy space in multiple layers, such as in a compensation layer and a bulk layer. Stress features 964 are depicted as being formed in the compensation layer 930 and causing volumetric expansion. The stress features 964 cause expansion in the Y direction (as depicted). Stress features 966 are depicted as being formed in the compensation layer 920 and causing volumetric contraction. The stress features 966 cause contraction in the Y direction (as depicted). Through application of multiple stress features, which may include multiple types of stress features, the positions of the features 942 may be corrected partially or wholly to the planned locations 940.

So, in an embodiment, stress in a die/substrate can introduce significant distortion, e.g., distortion in the location of features of a die. This stress can arise, for example, from the bonding process. This distortion magnitude could exceed the actuation range of adjustment knobs of the die processing equipment (e.g., of a die bonder, of lithographic apparatus, etc.) and/or lead to unacceptable overlay problems in subsequent process steps.

The distortion can be mitigated at least partly by depositing an additional stress compensation layer (such as one or more compensation layers 930 to an external surface of the die/substrate, e.g., to a bonded die/substrate), which induces an essentially opposite stress. In an embodiment, cuts/voids in the compensation layer are provided to reduce stress introduced by, e.g., the bonding process. Alternatively or additionally to an additional stress compensation layer, the cuts/voids may be introduced in an already existing layer of the die/substrate.

In an embodiment, the cuts/voids are arranged in a compensation pattern. In an embodiment, the cuts/voids can extend in two dimensions. For example, there can be a plurality of cuts/voids in one direction and a plurality of cuts/voids in an orthogonal direction. Cuts/voids in two dimensions can enable control of both X and Y distortions. In an embodiment, the cuts/voids comprise holes of a certain to-be-calculated density arranged in two dimensions to achieve the desired compensation stress pattern. In an embodiment, a direct write / maskless exposure tool (e.g., an e-beam writer) can be used to create the compensation pattern.

In an embodiment, the pattern may be created in the die/substrate after the die/substrate has been bonded to another die/substrate. So, in an embodiment, the bonded die/substrate is characterized by measuring the distortion (e.g., measuring a substrate grid distortion as known in the lithography alignment art), e.g. using an alignment system, a camera, etc. to measure features of the die/substrate which may be done by measuring existing or added marks, measuring circuit features, etc.

With the measured distortion, the compensation pattern is determined specific to the specific measured distortion such that the resulting bonded die/substrate distortion is minimized or reduced (or brought within the adjustment range of any subsequent processing equipment). In an embodiment, the compensation pattern is determined by software. In an embodiment, the compensation pattern is determined by an optimization to account for where a correction by the compensation pattern at one part may at least in part counteract a correction at another part or introduce an amount of distortion into the another part where there wasn't that amount of distortion otherwise. Any one or more of the techniques described above with respect to software application 430 can be used.

The compensation pattern is then formed in the compensation layer (or optionally split over a plurality of compensation layers, e.g., one does X direction distortions and another does Y direction distortions). As noted before, the compensation layer may be a layer specifically deposited to any of the bonded die/substrates for this purpose. Alternatively or additionally, the pattern may be applied in an already existing layer of (one of or both) the dies/substrates, e.g. a $SiO_2$ layer.

In an embodiment, the pattern may be created in the die/substrate before the die/substrate has been bonded to another die/substrate. For example, it may be assumed that the die/substrate-to-die/substrate stress variation is sufficiently small so that just one or more bonded dies/substrates can characterized to determine the distortion by measurement (e.g. using an alignment system). The above described techniques could be used to induce a similar but substantially opposite stress in one of the dies/substrates to be bonded before the bonding process takes place. After bonding, the resulting bonded die/substrate distortion is minimized or reduced (or brought within the adjustment range of any subsequent processing equipment).

In an embodiment, the stress and deformation (due to stress) of individual dies (especially after dicing) is not uniform. For example, a die in or from a central portion of a substrate can be less deformed than a die in or from an edge of a substrate. So, as will be appreciated, the various corrections described herein can be applied on a per die or group of dies basis, whether those dies have been diced from a substrate or whether still part of a substrate.

In an embodiment, the one or more compensation layers comprises a photoresist layer applied to a die/substrate. In an embodiment, the one or more layers into which a stress feature applied is a silicon dioxide layer/structure. In an embodiment, the stress features, e.g., cuts, voids, etc. are created by direct ablation of at least part of a layer, whether the layer is added or a pre-existing die/substrate layer.

In an embodiment, there can be a combination of parts of a die/substrate with stress features to create a desired deformation correction. For example, in an embodiment, stress features (e.g., cuts/voids or local deformation elements) can be created in a stress-relaxation layer / compensation layer or a layer at an external surface of the die/substrate, wherein these stress features provide compensation in a particular direction (e.g., contraction), and stress features (e.g., cuts/void s local deformation elements) can be created inside another part of the die/substrate (e.g., a bulk of the die/substrate, another stress-relaxation layer / compensation layer or another layer at an external surface of the die/substrate), wherein these stress features provide compensation in a different direction (e.g., expansion). So, for example, the stress features in a different parts of the die/substrates can work in opposite stress directions and thus allow for stress relaxation / reduction in different (e.g., opposite) directions. In an embodiment, radiation can be used to create in-bulk local deformation elements and radiation can be used (e.g., from a similar/same radiation source such as a laser) to ablate part of a surface to create relaxation in a different direction in order to enable optimal/desired correction for a (or per) die/substrate. In an embodiment, a same tool can be used to create these different sets of stress features. These multiple sets of stress features may be advantageous, for example, if more than two dies/substrates are stacked onto each other and the alignment of individual dies in the stack is significant.

So, in an embodiment, two or more different sets of stress features at different locations in or on the die/substrate may work in in at least partly opposite directions. For example, a first set of one or more stress features may bend the substrate/die in one direction while a second set of one or more stress features may bend the substrate/die in at least partly the opposite direction such that combining the two would allow for correction of any deformation that the substrate/die might have. For example, a stress relaxation layer can be etched with, e.g., cuts/voids to deform the substrate/die in a particular direction, while a part of the die/substrate can include local deformation elements that deform the die/substrate in an at least partly opposite direction so that combining the two would allow to correct any distortion that the substrate/die might have. Of course, the first and second sets can be the same type of stress feature (e.g., cuts/voids or local deformation elements) or different type of stress features (e.g., one being cuts/void and the other being local deformation elements). In an embedment, the first set is at a different depth within the die/substrate than the second set.

In an embodiment, an integrated circuit include any type of integrated circuit, including a photonic integrated circuit.

In an embodiment, the techniques and apparatus herein can be applied to die to die bonding, substrate to substrate bonding, die to substrate bonding, etc. For example, the techniques and apparatus herein can be applied to bonding an individual donor die to an individual target die. In an embodiment, the techniques and apparatus herein can be applied to bonding a group of donor dies to one or more target dies at a substantially same time or a group of target dies to one or more donor dies at a substantially same time. In an embodiment, the techniques and apparatus herein can be applied to bonding one or more donor dies to a substrate comprising one or more target dies formed therein or thereon or bonding one or more target dies to a substrate comprising one or more donor dies formed therein or thereon. In an embodiment, the techniques and apparatus herein can be applied to bonding a full or partial substrate comprising donor dies to one or more target dies or bonding a full or partial substrate comprising target dies to one or more donor dies. Thus, the techniques and apparatus herein can be applied to practically every form of die bonding, whether bonding dies individually, bonding dies in a group, bonding dies as part of a full or partial substrate, etc.

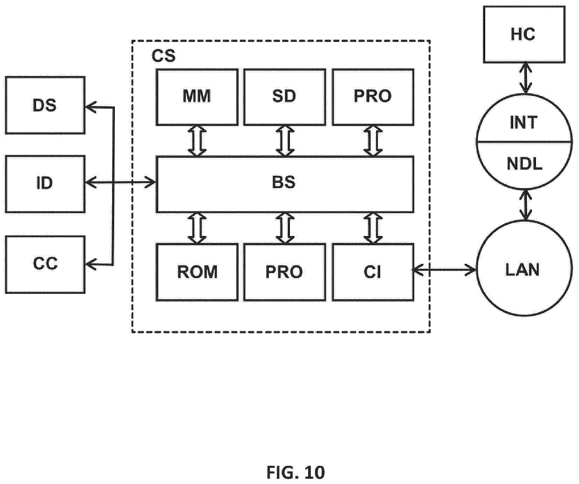

Figure 10 is a diagram of an example computer system CS that may be used to implement one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., X) and a second axis (e.g., Y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform one or more process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or radiation waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Embodiments include the following numbered clauses:

Clause 1: A method comprising:

generating a pattern of stress features, the pattern of stress features configured to alter locations of multiple fabricated features of a semiconductor die; and

applying at least part of the pattern of stress features to the semiconductor die to adjust locations of the multiple fabricated features.

Clause 2: The method of clause 1, further comprising:

obtaining measured locations of the multiple fabricated features on at least one area of the semiconductor die; determining a difference between the measured locations of the multiple fabricated features and planned locations of the multiple fabricated features; and

generating, based on the difference, the pattern of stress features.

Clause 3: The method of clause 2, wherein determining the difference comprises determining a distortion in the measured locations of the multiple features, the distortion resulting at least partially from stress in the semiconductor die.

Clause 4: The method of clause 2, wherein determining the difference comprises determining a difference between the measured locations of the multiple features and corresponding features on a further semiconductor die, wherein the semiconductor die is configured for bonding to the further semiconductor die.

Clause 5: The method of clause 4, wherein generating the pattern of stress features comprises generating a pattern of stress features calculated to alter the locations of the multiple fabricated features, the altered location of the multiple fabricated features configured to align with the corresponding features on the further semiconductor die.

Clause 6: The method of clause 4 or clause 5, further comprising bonding the semiconductor die to the further semiconductor die.

Clause 7: The method of any preceding clause, wherein at least part of the pattern of stress features is further configured to reduce stress in the semiconductor die.

Clause 8: The method of any preceding clause, wherein at least part of the pattern of stress features is further configured to increase stress in the semiconductor die.

Clause 9: The method of any preceding clause, wherein the stress features are induced in a buried layer and/or a surface layer.

Clause 10: The method of any preceding clause, wherein the stress features are induced in a compensation layer.

Clause 11: The method of clause 10, wherein the compensation layer is a pre-stressed layer.

Clause 12: The method of any preceding clause, wherein the stress features are induced using a laser.

Clause 13: The method of any preceding clause, wherein the stress features comprise microvoids and/or cuts.

Clause 14: The method of any preceding clause, wherein the semiconductor die is part of a substrate comprising multiple semiconductor dies.

Clause 15: The method of any of clauses 1 to 3 or clauses 7 to 14, further comprising bonding the semiconductor die to a further semiconductor die.

Clause 16: The method of clause 6 or clause 15, wherein the bonding comprises at least one selected from: van der Waals bonding, metallic bonding, and/or hybrid bonding.

Clause 17: The method of any of clause 6, clause 15 or clause 16, wherein the applying at least part of the pattern of stress features compensates for distortion resulting from stress at least partially caused by the bonding.

Clause 18: The method of any preceding clause, wherein the semiconductor die comprises a die containing integrated circuits.

Clause 19: A semiconductor die produced using the method of any preceding clause.

Clause 20: One or more non-transitory, machine-readable medium having instructions thereon, the instructions, when executed by a processor system, configured to cause the processor system to at least:

obtain measured locations of multiple fabricated features on at least one area of a semiconductor die; obtain planned locations of the multiple fabricated features on the at least one area of the semiconductor die; determine a difference between the measured fabricated locations of the multiple features and the planned locations of the multiple fabricated features; and

generate a pattern of stress features, the pattern of stress features configured to alter the locations of the multiple fabricated features based on the determined difference.

Clause 21: The medium of clause 20, wherein the instructions configured to cause the processor system to determine the difference are further configured to cause the processor system to determine a pattern of stress in the semiconductor die, the stress causing the difference between the measured locations and the planned locations.

Clause 22: One or more non-transitory, machine-readable medium having instructions thereon, the instructions, when executed by a processor system, configured to cause the processor system to at least:

determine a distortion in measured fabricated locations of multiple fabricated features on at least one area of a semiconductor die, the distortion resulting at least partially from stress in a bonding or fabrication process; and generate a pattern of stress features, the pattern of stress features configured to alter the distortion of the multiple fabricated features by altering the stress present in the semiconductor die.

Clause 23: The medium of any of clause 20 to 22, wherein the instructions configured to cause the processor system to generate the pattern of stress features are further configured to cause the processor system to generate a recipe for altering the semiconductor die by inducing the stress features in the semiconductor die.

Clause 24: The medium of clause 23, wherein the instructions configured to cause the processor system to generate the recipe are further configured to cause the processor system to generate a map of stress features with respect to the semiconductor die.

Clause 25: The medium of clause 24, wherein the instructions configured to generate the map are further configured to cause the processor system to generate the map of stress features with respect to depth in the semiconductor die.

Clause 26: The medium of clause 24 or clause 25, wherein the instructions are further configured to cause the processor system to determine, for each of the stress features, at least one selected from: an intensity of radiation, a number of pulses of radiation, and/or a time duration of delivery of radiation.

Clause 27: The medium of clause 26, wherein the instructions are further configured to cause the processor system to control a laser to deliver the radiation to the semiconductor die based on the recipe.

Clause 28: The medium of any of clauses 20 to 27, wherein the instructions configured to cause the processor system to generate the pattern of stress features are further configured to cause the processor system to generate one or more selected from: a stress feature to increase stress, a stress feature to reduce stress, a stress feature in a prestressed layer and/or a stress feature in a compensation layer.

Clause 29: The medium of any of clauses 20 to 28, wherein the instructions are further configured to cause the processor system to obtain target locations for the multiple fabricated features on at least one area of a further semiconductor die, wherein the pattern of stress features are further configured to alter the locations of the measured fabricated features to correspond to the target locations.

Clause 30: The medium of clause 29, wherein the instructions are further configured to cause the processor system to generate a second pattern of stress features, the second pattern of stress features configured to alter the target locations based on the measured fabricated locations of the multiple fabricated features.

Clause 31: A system comprising:

a targeted emission system configured to induce stress features in a semiconductor die; and
a processor system configured to:

obtain a pattern of stress features, the pattern of stress features configured to alter a distortion of the semiconductor die; and
cause the targeted emission system to generate stress features in the semiconductor die based on the pattern of stress features.

Clause 32: The system of clause 31, further comprising a measurement system configured to measure locations of features fabricated in the semiconductor die, wherein the processor is further configured to determine the distortion in the semiconductor die based on output of the measurement system, and to generate the pattern of stress features based on the determined distortion.

Clause 33: The system of clause 31 or clause 32, wherein the semiconductor die is a semiconductor die bonded to a further semiconductor die and wherein the distortion is caused, at least in part, by stress induced by the bonding.

Clause 34: The system of any of clauses 31 to 33, further comprising a bonding system configured to bond the semiconductor die to a further semiconductor die, and wherein the processor system is further configured to cause the bonding system to bond the semiconductor die to the further semiconductor die before determining the distortion or after causing the targeted emission system to generate the stress features.

Clause 35: The system of any of clauses 31 to 34, wherein the targeted emission system is a laser system.

Clause 36: A manufactured semiconductor die having a pattern of stress features, the pattern of stress features having altered locations of multiple fabricated features of the semiconductor die.

Clause 37: The semiconductor die of clause 36, comprising a further semiconductor die bonded thereto.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

**Claims**

1.  A method comprising:

    generating a pattern of stress features, the pattern of stress features configured to alter locations of multiple fabricated features of a semiconductor die; and
    applying at least part of the pattern of stress features to the semiconductor die to adjust locations of the multiple fabricated features.

2.  The method of claim 1, further comprising:

    obtaining measured locations of the multiple fabricated features on at least one area of the semiconductor die;
    determining a difference between the measured locations of the multiple fabricated features and planned locations of the multiple fabricated features; and
    generating, based on the difference, the pattern of stress features.

3.  The method of claim 2, wherein determining the difference comprises determining a distortion in the measured locations of the multiple features, the distortion resulting at least partially from stress in the semiconductor die.

4.  The method of claim 2, wherein determining the difference comprises determining a difference between the measured locations of the multiple features and corresponding features on a further semiconductor die, wherein the semiconductor die is configured for bonding to the further semiconductor die.

5.  The method of claim 4, wherein generating the pattern of stress features comprises generating a pattern of stress features calculated to alter the locations of the multiple fabricated features, the altered location of the multiple fabricated features configured to align with the corresponding features on the further semiconductor die.

6.  The method of claim 4, further comprising bonding the semiconductor die to the further semiconductor die.

7.  The method of claim 1, wherein at least part of the pattern of stress features is further configured to reduce stress in the semiconductor die, or wherein at least part of the pattern of stress features is further configured to increase stress in the semiconductor die.

8.  The method of claim 1, wherein the stress features are induced in a buried layer and/or a surface layer.

9.  The method of claim 1, wherein the stress features are induced in a compensation layer, wherein the compensation layer is a pre-stressed layer.

10. The method of claim 1, wherein the stress features comprise microvoids and/or cuts.

11. The method of claim 1, further comprising bonding the semiconductor die to a further semiconductor die.

12. The method of claim 6, wherein the applying at least part of the pattern of stress features compensates for distortion resulting from stress at least partially caused by the bonding.

13. A system comprising:

    a targeted emission system configured to induce stress features in a semiconductor die; and
    a processor system configured to:

obtain a pattern of stress features, the pattern of stress features configured to alter a distortion of the semiconductor die; and

cause the targeted emission system to generate stress features in the semiconductor die based on the pattern of stress features

wherein the targeted emission system comprises a femtosecond laser system.

14. The system of claim 14, further comprising a measurement system configured to measure locations of features fabricated in the semiconductor die, wherein the processor is further configured to determine the distortion in the semiconductor die based on output of the measurement system, and to generate the pattern of stress features based on the determined distortion.

15. The system of claim 13, further comprising a bonding system configured to bond the semiconductor die to a further semiconductor die, and wherein the processor system is further configured to cause the bonding system to bond the semiconductor die to the further semiconductor die before determining the distortion or after causing the targeted emission system to generate the stress features.

**FIG. 1A**

**FIG. 1B**

**FIG. 1C**

FIG. 1D

**FIG. 2A**

**FIG. 2B**

FIG. 2C

FIG. 2D

FIG. 2E

FIG. 2F

EP 4 576 085 A1

FIG. 3A

FIG. 3B

EP 4 576 085 A1

**FIG. 3C**

**FIG. 3D**

FIG. 3E

FIG. 3F

FIG. 3G

FIG. 3H

FIG. 3I

FIG. 3J

FIG. 4

FIG. 5

```
                    ┌──────────────────────────┐
                    │                          │
                    │           600            │
                    │                          │
                    └──────────────────────────┘
                                 │
                                 ▼
        ┌────────────────────────────────────────────────┐
        │                                                │
        │  610                                           │
        │                                                │
        │       ┌──────────────────────────────┐         │
        │       │                              │         │
        │       │             620              │         │
        │       │                              │         │
        │       └──────────────────────────────┘         │
        │                      │                         │
        │                      ▼                         │
        │       ┌──────────────────────────────┐         │
        │       │                              │         │
        │       │             630              │         │
        │       │                              │         │
        │       └──────────────────────────────┘         │
        │                                                │
        │                                                │
        └────────────────────────────────────────────────┘
                                 │
                                 ▼
                    ┌──────────────────────────┐
                    │                          │
                    │           END            │
                    │                          │
                    └──────────────────────────┘
```

**FIG. 6**

700

```
┌─────────────────┐
│       710       │
└─────────────────┘
         │
         ▼
┌─────────────────┐
│       720       │
└─────────────────┘
         │
         ▼
╱─────────────────╲
│       730       │◄────────┐
╲─────────────────╱         │
         │                  │
         ▼                  │
┌─────────────────┐         │
│       740       │         │
└─────────────────┘         │
         │              YES  │
         ▼                  │
┌─────────────────┐         │
│       750       │         │
└─────────────────┘         │
         │                  │
         ▼                  │
╲─────────────────╱         │
│       760       │─────────┘
╱─────────────────╲
         │
        NO
         ▼
┌─────────────────┐
│       770       │
└─────────────────┘
```

**FIG. 7**

FIG. 8

FIG. 9A

FIG. 9B

EP 4 576 085 A1

FIG. 10

Europäisches Patentamt

European Patent Office

Office européen des brevets

# EUROPEAN SEARCH REPORT

**Application Number**

EP 23 22 0057

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/309191 A1 (THEUSS HORST [DE]) 17 December 2009 (2009-12-17) * paragraph [0025] - paragraph [0053]; figures 1-15 * | 1-15 | INV. G11C5/04 G11C29/00 H01L21/66 H01L23/00 |
| X | US 2015/371908 A1 (BENCHER CHRISTOPHER DENNIS [US] ET AL) 24 December 2015 (2015-12-24) | 1-3 | ADD. B23K26/00 |
| A | * paragraph [0024] - paragraph [0050]; figures 3-7 * | 4-15 | G03F7/00 G11C29/02 G11C29/06 |
| A | US 2023/245996 A1 (SREENIVASAN SIDLGATA V [US] ET AL) 3 August 2023 (2023-08-03) * paragraph [0787] - paragraph [0792]; figures 108c,108d * | 4-6 | G11C29/56 H01L21/683 H01L23/544 H01L25/00 H01L25/065 |
| A | US 2016/336233 A1 (YONEHARA TAKAO [US] ET AL) 17 November 2016 (2016-11-17) * paragraph [0053] - paragraph [0060]; figures 1-5 * | 13-15 | |

**TECHNICAL FIELDS SEARCHED (IPC)**

G11C
G03F
H01L
B23K

The present search report has been drawn up for all claims

| Place of search | Date of completion of the search | Examiner |
|---|---|---|
| The Hague | 28 June 2024 | Kontogiannis, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT
## ON EUROPEAN PATENT APPLICATION NO.

EP 23 22 0057

This annex lists the patent family members relating to the patent documents cited in the above-mentioned European search report.
The members are as contained in the European Patent Office EDP file on
The European Patent Office is in no way liable for these particulars which are merely given for the purpose of information.

28-06-2024

| Patent document cited in search report | Publication date | Patent family member(s) | Publication date |
|---|---|---|---|
| US 2009309191 A1 | 17-12-2009 | DE 102009024585 A1 <br> US 2009309191 A1 | 17-12-2009 <br> 17-12-2009 |
| US 2015371908 A1 | 24-12-2015 | TW 201606274 A <br> US 2015371908 A1 <br> WO 2015195272 A1 | 16-02-2016 <br> 24-12-2015 <br> 23-12-2015 |
| US 2023245996 A1 | 03-08-2023 | NONE | |
| US 2016336233 A1 | 17-11-2016 | AU 2013222069 A1 <br> EP 2817819 A2 <br> JP 2015516672 A <br> KR 20140140053 A <br> US 2014038392 A1 <br> US 2016336233 A1 <br> WO 2013126927 A2 | 16-10-2014 <br> 31-12-2014 <br> 11-06-2015 <br> 08-12-2014 <br> 06-02-2014 <br> 17-11-2016 <br> 29-08-2013 |